# EUROPEAN PATENT APPLICATION

(11) **EP 4 550 963 A2**
(43) Date of publication of application: **07.05.2025**
(21) Application number: 24206167.9
(22) Date of filing: 11.10.2024
(51) Int. Cl.: H10B 12/00

(54) **SEMICONDUCTOR DEVICE AND METHOD FOR FABRICATING THE SAME**

(30) Priority: 31.10.2023 KR 20230148192
(71) Applicant: SK hynix Inc., Bubal-eub Icheon-si Gyeonggi-do 17336 (KR)
(72) Inventor: KIM, Seung Hwan, 17336 Icheon-si, Gyeonggi-do (KR); KWON, Jeong Hoon, 17336 Icheon-si, Gyeonggi-do (KR)
(74) Representative: Isarpatent

(57) **Abstract**

A semiconductor device includes a lower structure; a first region including a plurality of first conductive layers vertically stacked in a first direction over the lower structure; a second region including a plurality of second conductive layers stacked in the first direction, the second conductive layers having the same horizontal length; and a plurality of contact structures coupled to the second conductive layers, respectively, wherein each of the second conductive layers includes a first horizontal conductive line; a second horizontal conductive line; and a pad between the first horizontal conductive line and the second horizontal conductive line.

## Description

### BACKGROUND

### 1. Field

Various embodiments of the present disclosure relate to a semiconductor device, and more particularly, to a semiconductor device including three-dimensional (3D) memory cells, and a method for fabricating the semiconductor device.

### 2. Description of the Related Art

In order to cope with the demands for large-capacity and miniaturization of memory devices, technology has been suggested to provide a three-dimensional (3D) memory device in which a plurality of memory cells are stacked.

### SUMMARY

Embodiments of the present disclosure are directed to a semiconductor device including highly integrated memory cells, and a method for fabricating the semiconductor device.

In accordance with an embodiment of the present disclosure, a semiconductor device may include a lower structure; a first region including a plurality of first conductive layers vertically stacked in a first direction over the lower structure; a second region including a plurality of second conductive layers stacked in the first direction, the second conductive layers having the same horizontal length; and a plurality of contact structures coupled to the second conductive layers, respectively, wherein each of the second conductive layers includes a first horizontal conductive line; a second horizontal conductive line; and a pad between the first horizontal conductive line and the second horizontal conductive line.

In accordance with another embodiment of the present disclosure, a method for fabricating a semiconductor device includes forming a first stack of first conductive layers each including a pair of an upper horizontal conductive line and a lower horizontal conductive line over a lower structure; forming a second stack of second conductive layers each including a first horizontal conductive line, a second horizontal conductive line, and a pad between the first horizontal conductive line and the second horizontal conductive line over the lower structure; forming contact holes whose height gradually decreases in a direction that the second conductive layers are stacked in the second stack; and forming contact plugs respectively coupled to the second conductive layers exposed by the contact holes.

In accordance with another embodiment of the present disclosure, a semiconductor device includes a lower structure; a cell array region including a plurality of horizontal conductive lines vertically stacked in the first direction over the lower structure; a connection region including a plurality of levels stacked in the first direction and having the same horizontal length; and a plurality of contact structures respectively coupled to the levels, wherein each of the levels includes a first horizontal conductive line; a second horizontal conductive line; and a pad between the first horizontal conductive line and the second horizontal conductive line.

In accordance with another embodiment of the present disclosure, a semiconductor device includes an alternating stack of conductive layers and dielectric layers disposed over a lower structure; and an array of contact plugs disposed in the alternating stack, horizontally spaced apart from each other in a first horizontal direction, and having different heights, wherein top surfaces of the contact plugs are disposed on the same horizontal plane, and bottom portions of the contact plugs are coupled to the conductive layers, respectively, and wherein the contact plugs penetrating an uppermost conductive layer are laterally surrounded by the conductive layers and are laterally surrounded by the conductive layers laid over the conductive layers adjoined with the contact structure.

In accordance with another embodiment of the present disclosure, a semiconductor device includes a first cell array region and a second cell array region disposed laterally over a lower structure; a connection region disposed between the first cell array region and the second cell array region, and shared by the first cell array region and the second cell array region; and an array of contact plugs disposed in the connection region, horizontally spaced apart from each other in a first horizontal direction, and having different heights, wherein the first cell array region, the second cell array region, and the connection region include a vertical stack of common horizontal conductive lines, and the top surfaces of the contact plugs are disposed on the same horizontal plane, and the bottom portions of the contact plugs are coupled to the common horizontal conductive lines, and wherein the contact plugs penetrating an uppermost common horizontal conductive line are laterally surrounded by the common horizontal conductive lines, and are laterally surrounded by the common horizontal conductive lines laid over the common horizontal conductive lines adjoined with the contact structure.

In accordance with another embodiment of the present disclosure, a semiconductor device includes a lower structure; first and second memory cell arrays each containing a plurality of first conductive layers stacked over the lower structure; a connection portion disposed between the first and second memory cell arrays and containing of a plurality of second conductive layers, wherein each of the second conductive layers includes two horizontal conductive lines, and a pad between the two horizontal conductive lines.

Other features, aspects, and advantages of the embodiments of the present disclosure will become apparent from the following detailed description, the drawings, and the claims.

### BRIEF DESCRIPTION OF THE DRAWINGS

FIG. 1A is a schematic perspective view illustrating a memory cell in accordance with an embodiment of the present disclosure.
FIG. 1B is a schematic cross-sectional view illustrating the memory cell shown in FIG. 1A.
FIG. 1C is a plan view illustrating a switching element shown in FIG. 1A.
FIG. 2 is a schematic plan view illustrating a semiconductor device in accordance with an embodiment of the present disclosure.
FIG. 3A is a schematic perspective view illustrating a memory cell array MCA1 shown in FIG. 2.
FIG. 3B is a schematic cross-sectional view taken along a line A-A' shown in FIG. 2.
FIG. 3C is a schematic perspective view illustrating a sub-memory cell array MV1 shown in FIG. 2.
FIG. 3D is a schematic cross-sectional view taken along a line B-B' shown in FIG. 2.
FIGS. 4 to 22 illustrate a method for fabricating a semiconductor device in accordance with an embodiment of the present disclosure.
FIGS. 23 to 31 illustrate a method for forming a connection portion in accordance with an embodiment of the present disclosure.
FIGS. 32 to 40 are cross-sectional views illustrating a method for fabricating a semiconductor device in accordance with another embodiment of the present disclosure.
FIGS. 41 to 43 are cross-sectional views illustrating a method for fabricating a semiconductor device in accordance with another embodiment of the present disclosure.
FIGS. 44 to 46 are perspective views illustrating memory cell arrays in accordance with other embodiments of the present disclosure.

### DETAILED DESCRIPTION

Various embodiments of the present disclosure will be described below in more detail with reference to the accompanying drawings. The embodiments may, however, be embodied in different forms and should not be construed as limited to the embodiments set forth herein. Rather, these embodiments are provided so that this disclosure will be thorough and complete, and will fully convey the scope of the present disclosure to those skilled in the art. Throughout this disclosure, like reference numerals refer to like parts throughout the various figures and embodiments of the present disclosure. The drawings are not necessarily to scale and in some instances, proportions may have been exaggerated to clearly illustrate features of the embodiments. When a first layer is referred to as being "on" a second layer or "on" a substrate, it not only refers to a case where the first layer is formed directly on the second layer or the substrate but also a case where a third layer exists between the first layer and the second layer or the substrate.

The following embodiments described below relate to three-dimensional memory cells, and memory cells may be vertically stacked to increase a memory cell density and reduce parasitic capacitance.

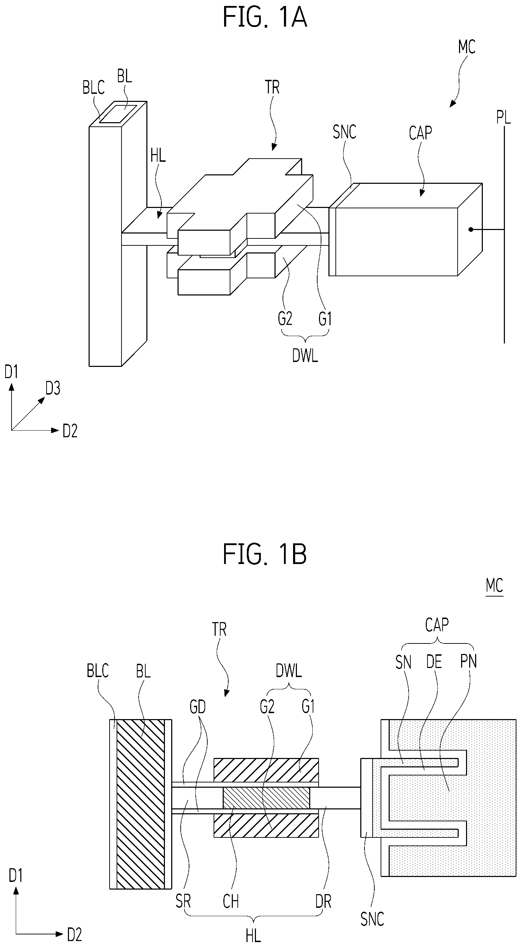

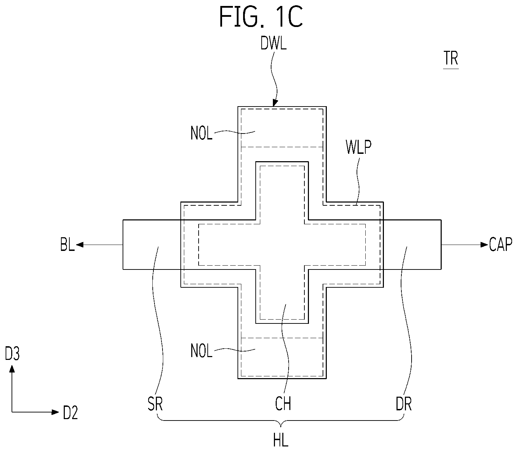

FIG. 1A is a schematic perspective view illustrating a memory cell in accordance with an embodiment of the present disclosure. FIG. 1B is a schematic cross-sectional view illustrating the memory cell shown in FIG. 1A. FIG. 1C is a plan view illustrating a switching element shown in FIG. 1A.

Referring to FIGS. 1A to 1C, the memory cell MC may include a first conductive line BL, a switching element TR, and a data storage element CAP.

The first conductive line BL may be vertically oriented in a first direction D1. The first conductive line BL may include a bit line. The first conductive line BL may be referred to as a vertical conductive line, a vertically-oriented bit line, a vertically-extending bit line, or a pillar-shaped bit line. The first conductive line BL may include a conductive material. The first conductive line BL may include a silicon-based material, a metal-based material, or a combination thereof. The first conductive line BL may include polysilicon, a metal, a metal nitride, a metal silicide, or a combination thereof. The first conductive line BL may include polysilicon, titanium nitride, tungsten, or a combination thereof. For example, the first conductive line BL may include a stack (TiN/W) of titanium nitride and tungsten.

The switching element TR may have a function of controlling a voltage (or current) supply to the data storage element CAP during a data write operation and a data read operation performed onto the data storage element CAP. The switching element TR may include a horizontal layer HL, an inter-level dielectric layer GD, and a second conductive line DWL. The second conductive line DWL may include a horizontal conductive line or a horizontal word line, and the horizontal layer HL may include an active layer. The switching element TR may include a transistor, and in this case, the second conductive line DWL may function as a gate electrode. The switching element TR may also be referred to as an access element or a selection element. The second conductive line DWL may be referred to as a horizontal gate electrode or a horizontal word line.

The horizontal layer HL may extend in a second direction D2 that intersects with the first direction D1. The second conductive line DWL may extend in a third direction D3 that intersects with the first direction D1 and the second direction D2. The first direction D1 may be a vertical direction, and the second direction D2 may be a first horizontal direction, and the third direction D3 may be a second horizontal direction. The horizontal layer HL may extend in the first horizontal direction (i.e., the second direction D2), and the second conductive line DWL may extend in the second horizontal direction (i.e., the third direction D3).

The horizontal layer HL may be horizontally oriented in the second direction D2 from the first conductive line BL. The second conductive line DWL may have a double structure. For example, the second conductive line DWL may include an upper horizontal line G1 and a lower horizontal line G2 that are facing each other with the horizontal layer HL interposed therebetween. An inter-level dielectric layer GD may be formed on the upper and lower surfaces of the horizontal layer HL. The upper horizontal line G1 may be disposed in the upper portion of the horizontal layer HL, and the lower horizontal line G2 may be disposed in the lower portion of the horizontal layer HL. The second conductive line DWL may include a pair of an upper horizontal line G1 and a lower horizontal line G2. In the second conductive line DWL, the same driving voltage may be applied to the upper horizontal line G1 and the lower horizontal line G2. For example, the upper horizontal line G1 and the lower horizontal line G2 may form a pair to be coupled to one memory cell MC. According to another embodiment of the present disclosure, different driving voltages may be applied to the upper horizontal line G1 and the lower horizontal line G2. In this case, one horizontal line among the upper horizontal line G1 or the lower horizontal line G2 may function as a back gate or a shield gate.

Referring back to FIG. 1C, each of the upper horizontal line G1 and the lower horizontal line G2 may have a width in the second direction D2, for example, the width of an overlapping portion that overlaps with the horizontal layer HL, which is greater than the width of a non-overlapping portion that does not overlap with the horizontal layer HL. Due to the difference in the widths, the second conductive line DWL may have a notch-shaped sidewall. The second conductive line DWL may include a channel overlapping portion WLP and a channel non-overlapping portion NOL. The channel overlapping portion WLP may refer to a portion that overlaps with a channel CH of the horizontal layer HL, and the channel non-overlapping portion NOL may refer to a portion that does not overlap with the horizontal layer HL. The channel overlapping portion WLP may have a cross shape as illustrated. In another embodiment the channel overlapping portion WLP may have a rhombus shape.

From the perspective of a top view, the horizontal layer HL may have a cross shape as illustrated, however, in another embodiment it may have a rhombus shape. According to another embodiment of the present disclosure, the side surfaces of the horizontal layer HL may have a bent shape or a rounded (or curved) shape.

The horizontal layer HL may include a semiconductor material. For example, the horizontal layer HL may include polysilicon, monocrystalline silicon, germanium, or silicon-germanium. According to another embodiment of the present disclosure, the horizontal layer HL may include an oxide semiconductor material. For example, the oxide semiconductor material may include Indium Gallium Zinc Oxide (IGZO). According to another embodiment of the present disclosure, the horizontal layer HL may include a conductive metal oxide. According to another embodiment of the present disclosure, the horizontal layer HL may include two-dimensional material. For example, the two-dimensional material may include MoS₂, MoSe₂, MoTe₂, WS₂, WSe₂, or WTe₂.

The upper (top) and lower (bottom) surfaces of the horizontal layer HL may be flat. The upper and lower surfaces of the horizontal layer HL may be parallel to each other in the second direction D2.

The horizontal layer HL may include a channel CH, a first doped region SR between the channel CH and the first conductive line BL, and a second doped region DR between the channel CH and the data storage element CAP. When the horizontal layer HL is formed of an oxide semiconductor material, the channel CH may be formed of an oxide semiconductor material, and the first and second doped regions SR and DR may be omitted. The horizontal layer HL may also be referred to as `an active layer or a thin-body'. The channel CH and the channel overlapping portion WLP of the second conductive line DWL may overlap with each other. The channel CH may have a cross shape as illustrated or a rhombus shape. The size of the channel overlapping portion WLP of the second conductive line DWL may be greater than that of the channel CH. The channel overlapping portion WLP of the second conductive line DWL may fully overlap with the channel CH.

The first doped region SR and the second doped region DR may be doped with impurities of the same conductivity type. The first doped region SR and the second doped region DR may be doped with an N-type conductive impurity or a P-type conductive impurity. The first doped region SR and the second doped region DR may include at least one impurity selected from among arsenic (As), phosphorus (P), boron (B), indium (In), and combinations thereof. The first doped region SR may be coupled to the first conductive line BL, and the second doped region DR may be coupled to the data storage element CAP. The first and second doped regions SR and DR may be referred to as `first and second source/drain regions.'

The inter-level dielectric layer GD may be disposed between the horizontal layer HL and the second conductive line DWL. The inter-level dielectric layer GD may be referred to as a gate dielectric layer. The inter-level dielectric layer GD may be referred to as a horizontal layer side dielectric layer. The inter-level dielectric layer GD may include silicon oxide, silicon nitride, a metal oxide, a metal oxynitride, a metal silicate, a high-k material, a ferroelectric material, an anti-ferroelectric material, or a combination thereof. The inter-level dielectric layer GD may include SiO₂, Si₃N₄, HfO₂, Al₂O₃, ZrO₂, AlON, HfON, HfSiO, HfSiON, HfZrO, or a combination thereof. The inter-level dielectric layer GD may be formed by a thermal oxidation process of a semiconductor material.

The second conductive line DWL may include a metal-based material, a semiconductor material, or a combination thereof. The second conductive line DWL may include titanium nitride, tungsten, polysilicon, or a combination thereof. For example, the second conductive line DWL may include a TiN/W stack in which titanium nitride and tungsten are sequentially stacked. The second conductive line DWL may include an N-type work function material or a P-type work function material. The N-type work function material may have a low work function of approximately 4.5 eV or less, and the P-type work function material may have a high work function of approximately 4.5 eV or more. The second conductive line DWL may include a stack of a low work function material and a high work function material.

The data storage element CAP may include a memory element, such as a capacitor. The data storage element CAP may be disposed horizontally in the second direction D2 from the switching element TR. The data storage element CAP may include a first electrode SN extending horizontally from the horizontal layer HL in the second direction D2. The data storage element CAP may further include a second electrode PN over the first electrode SN, and a dielectric layer DE between the first electrode SN and the second electrode PN. The first electrode SN, the dielectric layer DE, and the second electrode PN may be horizontally disposed in the second direction D2. The first electrode SN may include an inner space and a plurality of outer surfaces, and the inner space of the first electrode SN may include a plurality of inner surfaces. The outer surfaces of the first electrode SN may include a vertical outer surface and a plurality of horizontal outer surfaces. The vertical outer surface of the first electrode SN may extend vertically in the first direction D1, and the horizontal outer surfaces of the first electrode SN may extend horizontally in the second direction D2 or the third direction D3. The inner space of the first electrode SN may be a three-dimensional space. The dielectric layer DE may conformally cover the inner and outer surfaces of the first electrode SN. The second electrode PN may be disposed in the inner space of the first electrode SN over the dielectric layer DE. A portion of the outer surfaces of the first electrode SN may be electrically connected to the second doped region DR of the horizontal layer HL. The second electrode PN of the data storage element CAP may be coupled to a common plate PL.

The data storage element CAP may be a three-dimensional structure. The first electrode SN may have a three-dimensional structure, and the first electrode SN of the three-dimensional structure may have a horizontal three-dimensional structure that is oriented in the second direction D2. As an example of the three-dimensional structure, the first electrode SN may have a cylindrical shape. The cylindrical shape of the first electrode SN may include cylindrical inner surfaces and a cylindrical outer surface. A portion of the cylindrical outer surfaces of the first electrode SN may be electrically connected to the second doped region DR of the horizontal layer HL. The dielectric layer DE and the second electrode PN may be disposed on the cylindrical inner surfaces of the first electrode SN.

According to another embodiment of the present disclosure, the first electrode SN may have a pillar shape or a pylinder shape. The pylinder shape may refer to a structure in which a pillar shape and a cylindrical shape are merged.

The first electrode SN and the second electrode PN may include a metal, a noble metal, a metal nitride, a conductive metal oxide, a conductive noble metal oxide, a metal carbide, a metal silicide, or a combination thereof. For example, the first electrode SN and the second electrode PN may include titanium (Ti), titanium nitride (TiN), titanium silicon nitride (TiSiN), tantalum (Ta), tantalum nitride (TaN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, a tungsten nitride/tungsten (WN/W) stack, a titanium silicon nitride/titanium nitride (TiSiN/TiN) stack, or a combination thereof. The second electrode PN may include a combination of a metal-based material and a silicon-based material. For example, the second electrode PN may be a stack (TiN/SiGe/WN) of titanium nitride/silicon germanium/tungsten nitride. In the titanium nitride/silicon germanium/tungsten nitride (TiN/SiGe/WN) stack, silicon germanium may be a gap-fill material that fills the inside of the first electrode SN, and titanium nitride (TiN) may serve as the second electrode PN of the data storage element CAP, and tungsten nitride may be a low-resistance material.

The dielectric layer DE may be referred to as a capacitor dielectric layer or a memory layer. The dielectric layer DE may include silicon oxide, silicon nitride, a high-k material, a perovskite material, or a combination thereof. The high-k material may include hafnium oxide (HfO₂), zirconium oxide (ZrO₂), aluminum oxide (Al₂O₃), lanthanum oxide (La₂O₃), titanium oxide (TiO₂), tantalum oxide (Ta₂O₅), niobium oxide (Nb₂O₅) or strontium titanium oxide (SrTiO₃). According to another embodiment of the present disclosure, the dielectric layer DE may be formed of a composite layer including two or more layers of the aforementioned high-k materials.

The dielectric layer DE may be formed of zirconium-based oxide (Zr-based oxide). The dielectric layer DE may have a stack structure containing zirconium oxide (ZrO₂). The dielectric layer DE may include a ZA (ZrO₂/Al₂O₃) stack or a ZAZ (ZrO₂/Al₂O₃/ZrO₂) stack. The ZA stack may have a structure in which aluminum oxide (Al₂O₃) is stacked over zirconium oxide (ZrO₂). The ZAZ stack may have a structure in which zirconium oxide (ZrO₂), aluminum oxide (Al₂O₃), and zirconium oxide (ZrO₂) are sequentially stacked. The ZA stack and ZAZ stack may be referred to as a zirconium oxide-based layer (ZrO₂-based layer). According to another embodiment of the present disclosure, the dielectric layer DE may be formed of hafnium-based oxide (Hf-based oxide). The dielectric layer DE may have a stack structure containing hafnium oxide (HfO₂). The dielectric layer DE may include an HA (HfO₂/Al₂O₃) stack or an HAH (HfO₂/Al₂O₃/HfO₂) stack. The HA stack may have a structure in which aluminum oxide (Al₂O₃) is stacked over hafnium oxide (HfO₂). The HAH stack may have a structure in which hafnium oxide (HfO₂), aluminum oxide (Al₂O₃), and hafnium oxide (HfO₂) are sequentially stacked. The HA stack and HAH stack may be referred to as a hafnium oxide-based layer (HfO₂-based layer). In the ZA stack, ZAZ stack, HA stack, and HAH stack, aluminum oxide (Al₂O₃) may have a greater band gap energy than zirconium oxide (ZrO₂) and hafnium oxide (HfO₂). Aluminum oxide (Al₂O₃) may have a lower dielectric constant than zirconium oxide (ZrO₂) and hafnium oxide (HfO₂). Accordingly, the dielectric layer DE may include a stack of a high-k material and a high band gap material that has a greater band gap energy than the high-k material. The dielectric layer DE may include silicon oxide (SiO₂) as a high band gap material other than aluminum oxide (Al₂O₃). Leakage current may be suppressed by containing a high band gap material in the dielectric layer DE. The high band gap material may be thinner than the high-k material. According to another embodiment of the present disclosure, the dielectric layer DE may include a stack structure in which a high-k material and a high band gap material are alternately stacked. For example, the dielectric layer DE may include a ZAZA (ZrO₂/Al₂O₃/ZrO₂/Al₂O₃) stack, a ZAZAZ (ZrO₂/Al₂O₃/ZrO₂/Al₂O₃/ZrO₂) stack, a HAHA (HfO₂/Al₂O₃/HfO₂/Al₂O₃) stack, or a HAHAH (HfO₂/Al₂O₃/HfO₂/Al₂O₃/HfO₂) stack. In the above stack structures, aluminum oxide (Al₂O₃) may be thinner than zirconium oxide (ZrO₂) and hafnium oxide (HfO₂).

According to another embodiment of the present disclosure, the dielectric layer DE may include a high-k material and a high band gap material, and the dielectric layer DE may have a laminated structure in which a plurality of high-k materials and a plurality of high band gap materials are stacked, or a mixed structure in which a high-k material and a high band gap material are intermixed.

According to another embodiment of the present disclosure, the dielectric layer DE may include a ferroelectric material, an anti-ferroelectric material, or a combination thereof. For example, the dielectric layer DE may include HfZrO.

According to another embodiment of the present disclosure, the dielectric layer DE may include a combination of a high-k material and a ferroelectric material, a combination of a high-k material and an anti-ferroelectric material, or a combination of a high-k material or a ferroelectric material and an anti-ferroelectric material.

According to another embodiment of the present disclosure, an interface control layer may be further formed between the first electrode SN and the dielectric layer DE to improve leakage current. The interface control layer may include titanium oxide (TiO₂), tantalum oxide (Ta₂O₅), niobium oxide (Nb₂O₅), niobium nitride (NbN), or a combination thereof. The interface control layer may also be formed between the second electrode PN and the dielectric layer DE.

The data storage element CAP may include a three-dimensional capacitor. The data storage element CAP may include a Metal-Insulator-Metal (MIM) capacitor. The data storage element CAP may be replaced by another data storage material. For example, the data storage material may be a thyristor, a phase-change material, a Magnetic Tunnel Junction (MTJ), or a variable resistance material.

For example, the memory cell MC may include a thyristor, and the first conductive line BL may be a cathode line, and the data storage element CAP may be replaced by an anode line. Accordingly, the horizontal layer HL may include four semiconductor layers that are stacked in the second direction D2. The thyristor may include a first diode and a second diode that are coupled serially. When a forward bias of the same voltage is applied to the thyristor, the thyristor may have a high conductance state in which a large amount of current flows, or a low conductance state in which a small amount of current flows or no current flows. The memory cell MC according to this embodiment of the present disclosure may have a "1" state and a "0" state by using the high conductance state and the low conductance state of the thyristor, respectively.

Referring back to FIGS. 1A and 1B, the memory cell MC may further include a first contact node BLC and a second contact node SNC. The first contact node BLC may surround the outer wall of the first conductive line BL. The second contact node SNC may be disposed between the horizontal layer HL and the first electrode SN. The first contact node BLC may include a metal-based material or a semiconductor material. The second contact node SNC may include a metal-based material or a semiconductor material. For example, the first and second contact nodes BLC and SNC may include titanium, titanium nitride, tungsten, or a combination thereof. Also, the first and second contact nodes BLC and SNC may include doped polysilicon, and the first doped region SR and the second doped region DR may include impurities diffused from the first contact node BLC and the second contact node SNC, respectively.

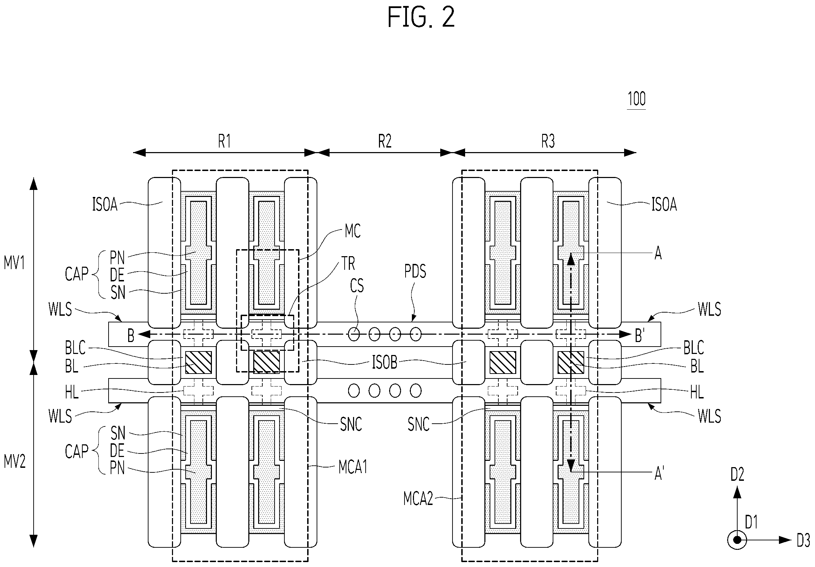

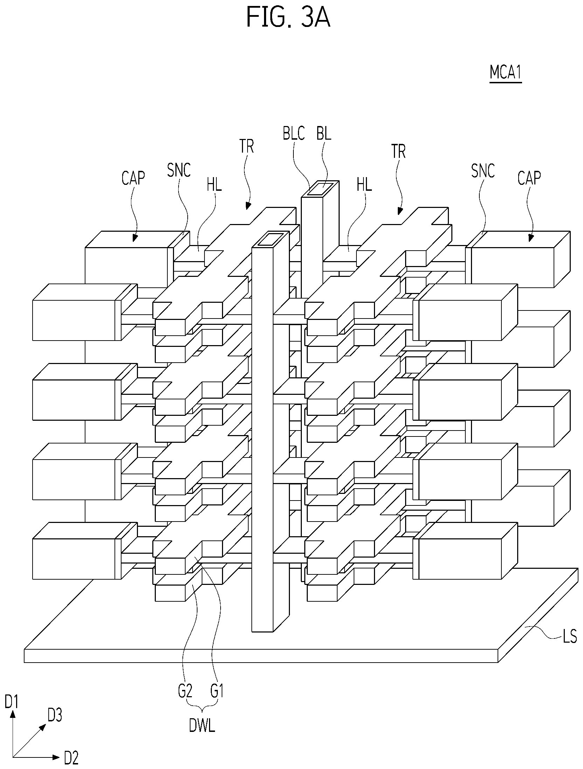

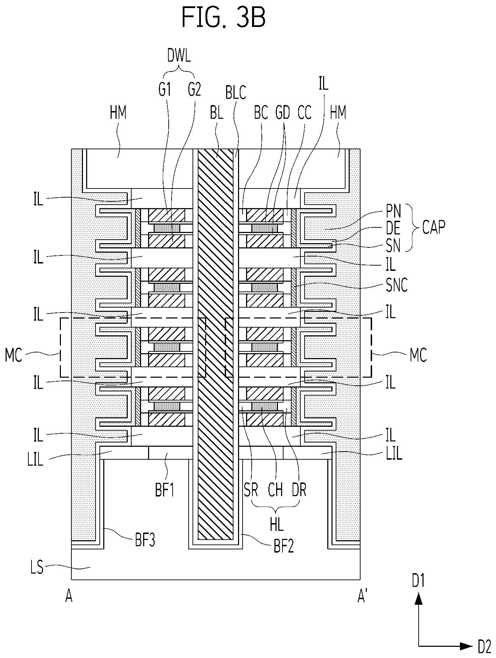

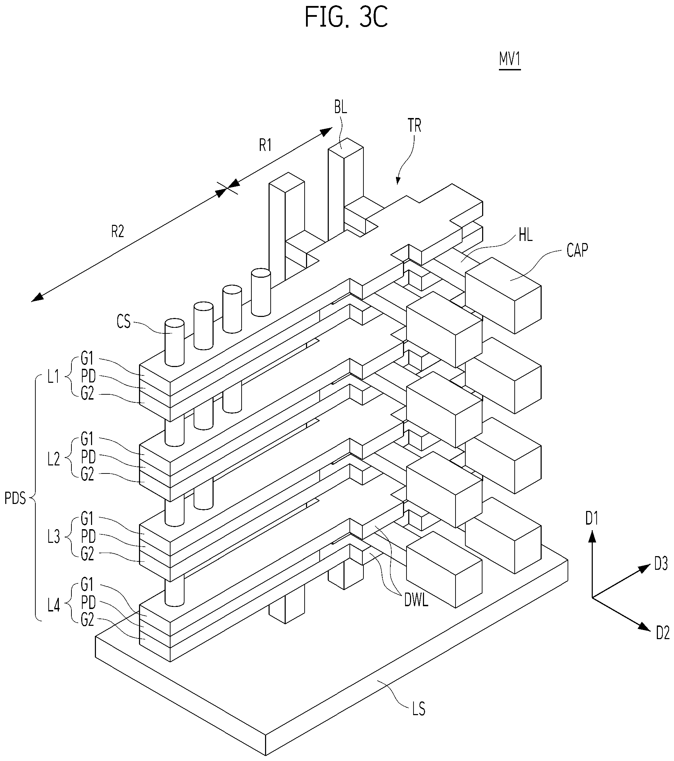

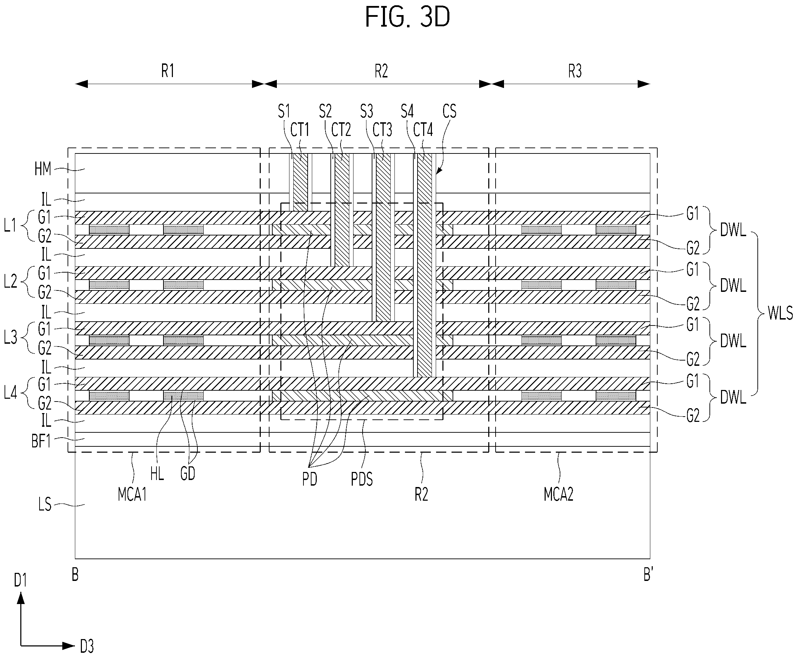

FIG. 2 is a schematic plan view illustrating a semiconductor device in accordance with an embodiment of the present disclosure. FIG. 3A is a schematic perspective view illustrating a memory cell array MCA1 shown in FIG. 2. FIG. 3B is a schematic cross-sectional view taken along a line A-A' shown in FIG. 2. FIG. 3C is a schematic perspective view illustrating a sub-memory cell array MV1 shown in FIG. 2. FIG. 3D is a schematic cross-sectional view taken along a line B-B' shown in FIG. 2.

Referring to FIGS. 2, 3A, 3B, 3C, and 3D, the semiconductor device 100 may include a first region R1 and a second region R2. The first region R1 may be a region where memory cells MC are formed, and the second region R2 may be a region where contact structures CS are formed. The contact structures CS of the second region R2 may be coupled to portions of the memory cells MC. The semiconductor device 100 may further include a third region R3, and the third region R3 may be a region where the memory cells MC are formed just like the first region R1. The first and third regions R1 and R3 may be referred to as memory cell regions, and the second region R2 may be referred to as a connection region. The first region R1 and the third region R3 may share the second region R2. The second region R2 may also be referred to as a sharing connection region, a sharing contact region, or a common contact region.

The semiconductor device 100 may include a plurality of memory cell arrays MCA1 and MCA2 that share the second region R2 and are spaced apart from each other in the third direction D3. Each of the memory cell arrays MCA1 and MCA2 may include a plurality of memory cells MC. As for the individual memory cells MC, FIGS. 1A to 1C may be referred to. Each memory cell MC may include a first conductive line BL, a switching element TR, and a data storage element CAP.

Each of the memory cell arrays MCA1 and MCA2 may include a three-dimensional array of memory cells MC. The three-dimensional array of memory cells MC may include a column array of memory cells MC and a row array of memory cells MC. The column array of memory cells MC may include a plurality of memory cells MC that are stacked in the first direction D1, and the row array of memory cells MC may include a plurality of memory cells MC that are horizontally arranged in the second direction D2 and the third direction D3. Each of the memory cell arrays MCA1 and MCA2 may have a mirror-type structure in which two memory cells MC share the first conductive line BL. According to another embodiment of the present disclosure, the semiconductor device 100 may further include sub-memory cell arrays having a mirror-type structure in which two memory cells MC share the second electrode PN of the data storage element CAP.

Each of the memory cell arrays MCA1 and MCA2 may include a vertical stack WLS extending long in the third direction D3. The vertical stack WLS may be disposed in the first region R1, the second region R2, and the third region R3.

Each of the memory cell arrays MCA1 and MCA2 may include a plurality of sub-memory cell arrays MV1 and MV2 sharing the second conductive line DWL in the third direction D3. Each of the sub-memory cell arrays MV1 and MV2 may include a vertical stack WLS extending long in the third direction D3. The vertical stack WLS may refer to second conductive lines DWL vertically stacked in the first direction D1. The vertical stack WLS may be disposed in the first region R1, the second region R2, and the third region R3. The vertical stack WLS may extend from the first region R1 to the second region R2 and the third region R3. Each of the second conductive lines DWL forming the vertical stack WLS may have an integrated structure extending from the first region R1 to the second region R2 and the third region R3.

Inter-cell dielectric layers IL may be disposed between the memory cells MC that are stacked in the first direction D1. The inter-cell dielectric layers IL may include, for example, silicon oxide and may be referred to as horizontal inter-cell dielectric layers. A hard mask layer HM may be disposed over the uppermost-level inter-cell dielectric layer IL.

Cell isolation layers ISOA and ISOB may be disposed between neighboring memory cells MC in the third direction D3. The cell isolation layers ISOA and ISOB may be referred to as vertical inter-cell dielectric layers. The cell isolation layers ISOA and ISOB may include silicon oxide, silicon carbon oxide (SiCO), silicon nitride, or a combination thereof. The cell isolation layers ISOA and ISOB may include first cell isolation layers ISOA and second cell isolation layers ISOB. The first and second cell isolation layers ISOA and ISOB may extend vertically in the first direction D1. The first and second cell isolation layers ISOA and ISOB may have a pillar structure extending vertically in the first direction D1. The first and second cell isolation layers ISOA and ISOB may be alternately repeatedly disposed in the second direction D2. The first cell isolation layers ISOA may be disposed between the data storage elements CAP in the third direction D3. The second cell isolation layers ISOB may be disposed between the first conductive lines BL in the third direction D3. The second conductive lines DWL may be disposed between the first and second cell isolation layers ISOA and ISOB in the second direction D2. Each of the first and second cell isolation layers ISOA and ISOB may include a stack of a cell isolation liner layer ISOL and a cell isolation gap-fill layer ISOG. The cell isolation liner layers ISOL may include silicon oxide, and the cell isolation gap-fill layers ISOG may include silicon carbon oxide.

The memory cell arrays MCA1 and MCA2 may be disposed over a lower structure LS.

The memory cell arrays MCA1 and MCA2 may include a plurality of second conductive lines DWL vertically stacked in the first direction D1. The memory cell arrays MCA1 and MCA2 may include a plurality of horizontal layers HL that are stacked vertically in the first direction D1. The memory cell arrays MCA1 and MCA2 may include a plurality of data storage elements CAP vertically stacked in the first direction D1. The memory cell arrays MCA1 and MCA2 may include a plurality of first conductive lines BL that are spaced apart from each other in the third direction D3.

Each of the second conductive lines DWL may include a channel overlapping portion WLP and a channel non-overlapping portion NOL as illustrated in FIG. 1C. The channel overlapping portion WLP may have a cross shape as illustrated. In another embodiment the channel overlapping portion WLP may have a rhombus shape. The channel overlapping portion WLP may fully overlap with the channel CH. The second conductive line DWL extending in the third direction D3 may include a plurality of channel overlapping portions WLP. As the channel overlapping portions WLP and the channel non-overlapping portions NOL are alternately repeated in the third direction D3, the second conductive line DWL may have a notch-shaped sidewall.

A plurality of first passivation layers BF1 may be disposed between the lowermost second conductive line DWL among the second conductive lines DWL and the lower structure LS. A second passivation layer BF2 may be disposed between the first conductive line BL and the lower structure LS. Third passivation layers BF3 may be disposed between the data storage element CAP and the lower structure LS. The first to third passivation layers BF1, BF2 and BF3 may include a dielectric material. The first to third passivation layers BF1, BF2 and BF3 may include silicon oxide. The first conductive line BL, the second conductive lines DWL, and the data storage elements CAP may be electrically disconnected from the lower structure LS by the first to third passivation layers BF1, BF2 and BF3. The first to third passivation layers BF1, BF2 and BF3 may be referred to as bottom dielectric layers or bottom passivation layers. A lowermost-level inter-cell dielectric layer LIL may be disposed between the first passivation layers BF1 and the data storage element CAP.

The first conductive lines BL may extend vertically in the first direction D1 from the upper portion of the lower structure LS. The horizontal layers HL may extend in the second direction D2 that intersects with the first direction D1. The second conductive lines DWL may extend in the third direction D3 that intersects with the first direction D1 and the second direction D2.

From the perspective of a top view, the horizontal layers HL may have a cross shape or rhombus shape. According to another embodiment of the present disclosure, the side surfaces of the horizontal layer HL may have a bent shape or a rounded (or curved) shape. As illustrated in FIG. 1B, the horizontal layer HL may include a channel CH, a first doped region SR between the channel CH and the first conductive line BL, and a second doped region DR between the channel CH and the data storage element CAP.

The first capping layer BC may be disposed between the second conductive line DWL and the first conductive line BL. A second capping layer CC may be disposed between the second conductive line DWL and the first electrode SN of the data storage element CAP. The first capping layer BC may be disposed between the upper horizontal line G1 and the first conductive line BL, and the first capping layer BC may be disposed between the lower horizontal line G2 and the first conductive line BL. The second capping layer CC may be disposed between the upper horizontal line G1 and the first electrode SN of the data storage element CAP, and also the second capping layer CC may be disposed between the lower horizontal line G2 and the first electrode SN of the data storage element CAP. One memory cell MC may include a pair of first capping layers BC and a pair of second capping layers CC.

The first and second capping layers BC and CC may include a dielectric material. The first and second capping layers BC and CC may include silicon oxide, silicon nitride, silicon carbon oxide, an air gap, or a combination thereof. The first capping layer BC may include silicon oxide, and the second capping layer CC may include a stack of silicon oxide and silicon nitride.

The memory cell MC may further include a first contact node BLC and a second contact node SNC. The first contact node BLC may surround the outer wall of the first conductive line BL. The second contact node SNC may be disposed between the horizontal layer HL and the first electrode SN. The first contact node BLC may include a metal-based material or a semiconductor material. The second contact node SNC may include a metal-based material or a semiconductor material. For example, the first and second contact nodes BLC and SNC may include titanium, titanium nitride, tungsten, or a combination thereof. Also, the first and second contact nodes BLC and SNC may include doped polysilicon, and the first doped region SR and the second doped region DR may include impurities diffused from the first and second contact nodes BLC and SNC, respectively.

The horizontal layers HL of the switching elements TR arranged horizontally in the third direction D3 may share one second conductive line DWL. The horizontal layers HL of the switching elements TR arranged horizontally in the third direction D3 may be coupled to different first conductive lines BL. The switching elements TR stacked in the first direction D1 may share one first conductive line BL. The switching elements TR arranged horizontally in the third direction D3 may share one second conductive line DWL.

First cell isolation layers ISOA may be disposed between the first electrodes SN of the data storage elements CAP in the third direction D3. The first electrodes SN may be isolated from each other by the first cell isolation layers ISOA. The second electrodes PN of the data storage elements CAP may be coupled to a common plate PL.

The lower structure LS may include a semiconductor substrate, a metal interconnection structure, a dielectric structure, a conductive structure, a bonding pad structure, another memory or a peripheral circuit portion.

For example, the lower structure LS may include a structure in which a peripheral circuit portion, a metal interconnection structure, and a bonding pad structure are stacked in the mentioned order. The memory cell arrays MCA1 and MCA2 and the peripheral circuit portion of the lower structure LS may be bonded by wafer bonding.

The peripheral circuit portion of the lower structure LS may be disposed at a lower level than the memory cell arrays MCA1 and MCA2. This may be referred to as COP (Cell-Over-Peripheral) structure. The peripheral circuit portion may include at least one control circuit for driving the memory cell arrays MCA1 and MCA2. The at least one control circuit of the peripheral circuit portion may include an N-channel transistor, a P-channel transistor, a CMOS circuit, or a combination thereof. The at least one control circuit of the peripheral circuit portion may include an address decoder circuit, a read circuit, a write circuit, and the like. The at least one control circuit of the peripheral circuit portion may include a planar channel transistor, a recess channel transistor, a buried gate transistor, a fin channel transistor (FinFET), and the like.

For example, the peripheral circuit portion may include sub-word line drivers and a sense amplifier. The first conductive line BL may be coupled to the sense amplifier, and the second conductive lines DWL may be coupled to the sub-word line drivers.

According to another embodiment of the present disclosure, the peripheral circuit portion may be disposed at a higher level than the memory cell arrays MCA1 and MCA2. This may be referred to as POC (Peripheral-Over-Cell) structure.

According to another embodiment of the present disclosure, the memory cell arrays MCA1 and MCA2 may include a Dynamic Random Access Memory (DRAM), an embedded DRAM, a NAND, a ferroelectric RAM (FeRAM), a Spin Transfer Torque RAM (STTRAM), a Phase-Change RAM (PCRAM), or a Resistive RAM (ReRAM).

Referring to FIGS. 3C and 3D, the sub-memory cell array MV1 of the memory cell arrays MCA1 and MCA2 may include a vertical stack WLS and a connection portion PDS.

The vertical stack WLS may be disposed in the first region R1 and the third region R3, and the connection portion PDS may be disposed in the second region R2. The vertical stack WLS and the connection portion PDS may include second conductive lines DWL that are stacked in the first direction D1. The second conductive lines DWL may include a plurality of levels L1, L2, L3 and L4. The levels L1 to L4 may be horizontal levels extending in the third direction D3. The first level L1 may refer to the horizontal conductive line DWL of the uppermost level, and the fourth level L4 may refer to the horizontal conductive line DWL of the lowermost level. The second level L2 may be a lower level than the first level L1, and the third level L3 may be a lower level than the second level L2. The fourth level L4 may be a lower level than the third level L3.

The fourth level L4, the third level L3, the second level L2, and the first level L1 may be stacked in the first direction D1 in the mentioned order.

The horizontal conductive line DWL at each level L1 to L4 of the vertical stack WLS may include a pair of an upper horizontal line G1 and a lower horizontal line G2. The horizontal conductive line DWL of each level L1 to L4 of the connection portion PDS may include a pair of an upper horizontal line G1 and a lower horizontal line G2. As such, the second conductive lines DWL may be disposed in the first region R1 and the third region R3, and portions of the second conductive lines DWL may extend to the second region R2. Portions of the second conductive lines DWL disposed in the second region R2 may form a connection portion PDS. The connection portion PDS may be referred to as a contact portion, an edge portion, or a pad portion.

Each of the levels L1 to L4 in the connection portion PDS may further include pads PD. The pads PD may be disposed between the upper horizontal line G1 and the lower horizontal line G2. Each of the pads PD may be electrically connected to the upper horizontal line G1 and the lower horizontal line G2. The connection portion PDS may further include inter-cell dielectric layers IL that are disposed between the levels L1 to L4.

The vertical stack WLS may further include horizontal layers HL and inter-level dielectric layers GD, and the horizontal layers HL and the inter-level dielectric layers GD may be disposed between the upper horizontal line G1 and the lower horizontal line G2. The vertical stack WLS may further include inter-cell dielectric layers IL between the second conductive lines DWL. The inter-cell dielectric layers IL may extend from the vertical stack WLS to the connection portion PDS.

The lateral lengths of the pads PD in the third direction D3 may be the same. The pads PD and the horizontal layers HL may be spaced apart from each other. The pads PD may be disposed in the second region R2, and the pads PD may not be disposed in the first region R1 and the third region R3.

The pads PD, the upper horizontal lines G1, and the lower horizontal lines G2 may include the same material. The pads PD, the upper horizontal lines G1, and the lower horizontal lines G2 may include a metal-based material. For example, the pads PD, the upper horizontal lines G1 and the lower horizontal lines G2 may include titanium nitride, tungsten, or a combination thereof. The pads PD, the upper horizontal lines G1 and the lower horizontal lines G2 may contain metal-based materials.

The second region R2 may include a contact structure CS that is coupled to each of the second conductive lines DWL of the connection portion PDS. The contact structure CS may include contact plugs CT1, CT2, CT3, and CT4 and contact spacers S1, S2, S3, and S4.

The second and third regions R2 and R3 may each include an alternating stack of the second conductive lines DWL and the inter-cell dielectric layers IL, and an array of contact plugs CT1, CT2, CT3 and CT4 disposed in the alternating stack, laterally spaced apart from each other in the second horizontal direction (i.e., the third direction D3) and having different heights. The top surfaces of the contact plugs CT1, CT2, CT3, and CT4 may be disposed on the same horizontal plane. The bottom portions of the contact plugs CT1, CT2, CT3, and CT4 may be respectively adjoined with the second conductive lines DWL. Each of the contact plugs CT2, CT3 and CT4 penetrating the uppermost second conductive line DWL may be surrounded laterally by the second conductive lines DWL laid over the second conductive lines DWL adjoined with the contact structure CS.

The first contact plug CT1 may be electrically connected to the second conductive line DWL of the first level L1. The first contact plug CT1 may be electrically connected to the upper horizontal line G1 of the first level L1. The second contact plug CT2 may be electrically connected to the second conductive line DWL of the second level L2. The second contact plug CT2 may be electrically connected to the upper horizontal line G1 of the second level L2. The third contact plug CT3 may be electrically connected to the second conductive line DWL of the third level L3. The third contact plug CT3 may be electrically connected to the upper horizontal line G1 of the third level L3. The fourth contact plug CT4 may be electrically connected to the second conductive line DWL of the fourth level L4. The fourth contact plug CT4 may be electrically connected to the upper horizontal line G1 of the fourth level L4.

A first contact spacer S1 may be disposed on a sidewall of the first contact plug CT1. A second contact spacer S2 may be disposed on a sidewall of the second contact plug CT2. A third contact spacer S3 may be disposed on a sidewall of the third contact plug CT3. A fourth contact spacer S4 may be disposed on a sidewall of the fourth contact plug CT4. The vertical height of the fourth contact plug CT4 may be greater than vertical height of the third contact plug CT3. The vertical height of the third contact plug CT3 may be greater than the vertical height of the second contact plug CT2. The vertical height of the second contact plug CT2 may be greater than the vertical height of the first contact plug CT1. The vertical height refers to the height in the first direction D1.

The fourth contact plug CT4 and the fourth contact spacer S4 may penetrate the pads PD and the upper and lower horizontal lines G1 and G2 of the first, second, and third levels L1, L2, and L3. The fourth contact plug CT4 may be electrically disconnected from the pads PD of the first level L1, the second level L2 and the third level L3, and the upper and lower horizontal lines G1 and G2 by the fourth contact spacer S4.

The third contact plug CT3 and the third contact spacer S3 may penetrate the pads PD of the first level L1 and the second level L2, and the upper and lower horizontal lines G1 and G2. The third contact plug CT3 may be electrically disconnected from the pads PD of the first level L1 and the second level L2 and the upper and lower horizontal lines G1 and G2 by the third contact spacer S3.

The second contact plug CT2 and the second contact spacer S2 may penetrate the pad PD of the first level L1 and the upper and lower horizontal lines G1 and G2. The second contact plug CT2 may be electrically disconnected from the pad PD of the first level L1 and the upper and lower horizontal lines G1 and G2 by the second contact spacer S2.

Referring back to FIG. 3D from another perspective, the semiconductor device 100 may include a first cell array region R1 and a second cell array regions R3 disposed in a lateral direction over the lower structure LS and a connection region R2 disposed between the first and second cell array regions R1 and R3. The connection region R2 is shared by the first and second cell array regions R1 and R3. Furthermore, an array of contact plugs CT1 to CT4 are disposed in the connection region R2 and are horizontally spaced apart from each other in the first horizontal direction D3. The contact plugs CT1 to CT4 have different heights. Here, the first cell array region R1, the second cell array region R3 and the connection region R2 may include a stack of common second conductive lines DWL, and the top surfaces of the contact plugs CT1 to CT4 may be disposed on the same horizontal plane, and the bottom portions of the contact plugs CT1 to CT4 may be coupled to the common second conductive lines DWL, and the contact plugs CT2 to CT4 penetrating the uppermost common second conductive line DWL may be laterally surrounded by the common second conductive lines DWL and laterally surrounded by the common second conductive lines DWL laid over the common second conductive lines DWL adjoined with the contact plugs CT2 to CT4, respectively.

Also, the contact plugs CT2 to CT4 may penetrate the common second conductive line DWL of the first level L1. The contact plugs CT2 to CT4 may be laterally surrounded by the common second conductive line DWL of the first level L1, and the contact plug CT2 may be laterally surrounded by the common second conductive line DWL of the first level L1. The contact plug CT3 may be laterally surrounded by the common second conductive lines DWL of the first and second levels, and the contact plug CT4 may be laterally surrounded by the common second conductive lines DWL of the first, second and third levels L1, L2 and L3. The contact plug CT4 may be laterally surrounded by the common second conductive line DWL of the third level L3 laid over the common second conductive line DWL of the fourth level L4 adjoined with the contact plug CT4. The contact plug CT3 may be laterally surrounded by the common second conductive line DWL of the second level L2 laid over the common second conductive line DWL of the third level L3 adjoined with the contact plug CT3. The contact plug CT2 may be laterally surrounded by the common second conductive line DWL of the first level L1 laid over the common second conductive line DWL of the second level L2 adjoined with the contact plug CT2.

According to the above description, the second conductive lines DWL of the connection portion PDS may have a stair-less structure. Since the connection portion PDS is formed in a stair-less structure, the occupied area (or volume) of the connection portion PDS may be reduced in the second region R2. Also, since the first region R1 and the third region R3 share one second region R2, the area where the second region R2 is formed may be reduced.

As a comparative example, when the connection portion is formed in a stepped structure, each of the first region R1 and the third region R3 may include a stepped second region R2, and thus the increased second regions R2 may increase the area of the semiconductor device.

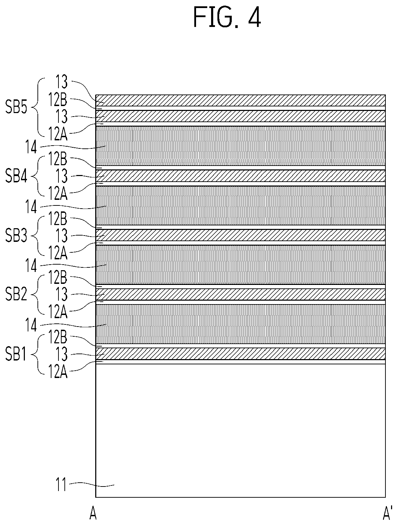

FIGS. 4 to 22 illustrate an example of a method for fabricating a semiconductor device in accordance with an embodiment of the present disclosure. FIGS. 4 to 22 illustrate the fabrication method according to the line A-A' shown in FIG. 2. Hereinafter, as for the first direction D1, the second direction D2 and the third direction D3, the first to third directions D1, D2, and D3 shown in FIG. 2 may be referred to.

Referring to FIG. 4, a stack body SB may be formed over the lower structure 11. The lower structure 11 may be a material appropriate for semiconductor processing, including, for example, at least one or more from among a conductive material, a dielectric material, and a semiconductive material. Diverse materials may be formed over the lower structure 11. The lower structure 11 may include a semiconductor substrate such as, for example, silicon, including monocrystalline silicon, polysilicon, amorphous silicon. The lower structure 11 may also include other materials such as germanium, silicon germanium, monocrystalline silicon germanium, polycrystalline silicon germanium, carbon-doped silicon, a combination thereof, and a multi-layer thereof. The lower structure 11 may include a III/V-group semiconductor substrate, for example, a compound semiconductor substrate, such as GaAs. The lower structure 11 may include a Silicon-On-Insulator (SOI) substrate.

The stack body SB may include a plurality of sub-stacks that are alternately stacked. Each of the sub-stacks may include a first layer 12A, a second layer 13, a third layer 12B, and a fourth layer 14 that are stacked in the mentioned order. The first layers 12A and the third layers 12B may include the same material, such as, for example, silicon germanium or monocrystalline silicon germanium. The second layers 13 and the fourth layers 14 may be made of the same material, such as, for example, monocrystalline silicon. The first layers 12A, the second layers 13, the third layers 12B, and the fourth layers 14 may be formed by an epitaxial growth process. The lowermost-level first layer 12A may serve as a seed layer during the epitaxial growth process. The first layers 12A may be thinner than the second layers 13, and the fourth layers 14 may be thicker than the second layers 13.

According to this embodiment of the present disclosure, the stack body SB may include a plurality of fourth layers 14, a first sacrificial layer stack SB1, a second sacrificial layer stack SB2, a third sacrificial layer stack SB3, a fourth sacrificial layer stack SB4, and a fifth sacrificial layer stack SB5. The stack body SB may include a first stack SB1, a fourth layer 14, a second stack SB2, a fourth layer 14, a third stack SB3, a fourth layer 14, a fourth stack SB4, a fourth layer 14, and a fifth stack SB5 that are stacked in the mentioned order. The second layer 13 may be disposed at the uppermost-level of the stack body SB. Each of the first to fifth stacks SB1 to SB5 may be a three-layer stack of the first layer 12A/the second layer 13/the third layer 12B. For example, when the first layers 12A and the third layers 12B include a silicon germanium layer and the second layers 13 include a monocrystalline silicon layer, the first to fifth stacks SB1 to SB5 may include a stack (SiGe/Si/SiGe) of a first silicon germanium/monocrystalline silicon/a second silicon germanium. The fifth stack SB5 may further include a second layer 13 over the three-layer stack of the first layer 12A/the second layer 13/the third layer 12B.

The second layers 13 may include a first monocrystalline silicon layer, and the fourth layers 14 may include a second monocrystalline silicon layer. The second monocrystalline silicon layers may be thicker than the first monocrystalline silicon layers. Accordingly, in the stack body SB, the first stack SB1 may be disposed below the second monocrystalline silicon layers, and the second stack SB2 may be disposed over the second monocrystalline silicon layers. Each of the first and second stacks SB1 and SB2 may include a stack of a first silicon germanium layer/a first monocrystalline silicon layer/a second silicon germanium layer, and the second monocrystalline silicon layers may be thicker than the first monocrystalline silicon layers.

The first layers 12A, the second layers 13, and the third layers 12B may be referred to as 'sacrificial layers,' and the fourth layers 14 may be referred to as recess target layers. The stack body SB may be referred to as a vertical stack. The stack body SB may be formed by alternating a plurality of sacrificial layers and the recess target layers. The sacrificial layers may include first to fifth stacks SB1 to SB5, and each of the first to fifth stacks SB1 to SB5 may include a three-layer stack of the first layer 12A/the second layer 13/the third layers 12B. The recess target layers may include the fourth layers 14. Each of the sacrificial layers may include a three-layer stack of a first silicon germanium layer/a first monocrystalline silicon layer/a second silicon germanium layer, and each of the recess target layers may include a single layer of a second monocrystalline silicon layer, and the second monocrystalline silicon layers may be thicker than the first monocrystalline silicon layers.

Referring to FIGS. 2 to 3D described above, when memory cells are stacked, the first sacrificial layer stack SB1, the fourth layer 14, the second sacrificial layer stack SB2, the fourth layer 14, the third sacrificial layer stack SB3, the fourth layer 14, the fourth sacrificial layer stack SB4, the fourth layer 14, and the fifth sacrificial layer stack SB5 may be alternately stacked several times.

According to another embodiment of the present disclosure, the fourth layer 14 may include amorphous silicon or polysilicon.

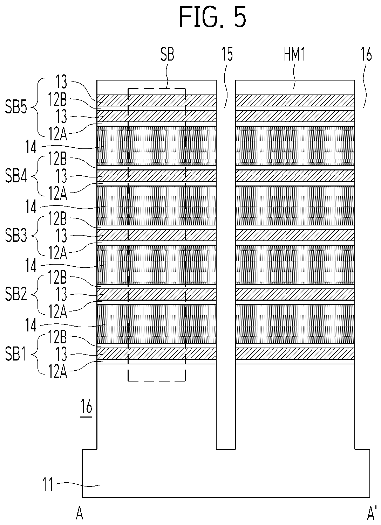

Referring to FIG. 5, portions of the stack body SB may be etched to form a plurality of first and second vertical openings 15 and 16 in the stack body SB. From the perspective of a top view, the first vertical openings 15 and the second vertical openings 16 may be hole-type vertical openings. According to another embodiment of the present disclosure, the first vertical openings 15 and the second vertical openings 16 may be line-shaped vertical openings. From the perspective of a top view, the cross-sections of the first and second vertical openings 15 and 16 may be a square shape, a circular shape or an oval shape.

As described above, a hard mask layer pattern HM1 may be formed to form the vertical openings 15 and 16, and the hard mask layer pattern HM1 may be formed using a double patterning process. The hard mask layer pattern HM1 may include silicon nitride. The hard mask layer pattern HM1 may be formed by an etching process using a mask layer. The hard mask layer pattern HM1 may have a plurality of hole-type openings defined therein.

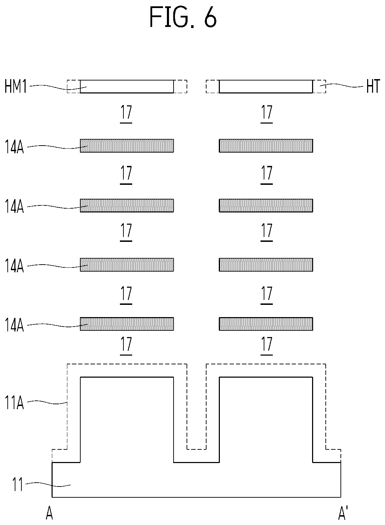

Referring to FIG. 6, a portion HT of the hard mask layer pattern HM1 may be trimmed.

The first and third layers 12A and 12B may be selectively removed through the first and second vertical openings 15 and 16. The first layers 12A and the third layers 12B may be selectively removed by using the difference in etch selectivity between the second and fourth layers 13 and 14 and the first and third layers 12A and 12B. The first layers 12A and the third layers 12B may be removed by a wet etching process or a dry etching process. For example, when the first layers 12A and the third layers 12B include a silicon germanium layer, and the second layers 13 and the fourth layers 14 include a monocrystalline silicon layer, the silicon germanium layers may be etched by using an etchant or an etching gas having a selectivity with respect to the monocrystalline silicon layers.

The second layers 13 and the fourth layers 14 may be recessed. To recess the second layers 13 and the fourth layers 14, a wet etching process or a dry etching process may be performed. According to this embodiment of the present disclosure, the fourth layers 14 may be partially etched while the second layers 13 are removed. As a result, the second layers 13 may be removed, and the fourth layers 14 may become thin, as indicated by a reference numeral '14A'. The recess process for forming the thin fourth layers 14A, which are the preliminary horizontal layers 14A, may be referred to as a thinning process or a trimming process of the fourth layers 14. To form the preliminary horizontal layers 14A, the upper surfaces, lower surfaces, and side surfaces of the fourth layers 14 may be recessed. The preliminary horizontal layers 14A may be referred to as a thin-body active layer. The preliminary horizontal layers 14A may include a monocrystalline silicon layer. The recess process for forming the preliminary horizontal layers 14A may use, for example, HSC1 (Hot SC-1). HSC1 may include a solution of ammonium hydroxide (NH₄OH), hydrogen peroxide (H₂O₂), and water (H₂O) that are mixed at a ratio of approximately 1:4:20. The second layers 13 and the fourth layers 14 may be selectively etched by using HSC1.

The preliminary horizontal layers 14A may be formed by the recess process for the fourth layers 14 as described above, and horizontal recesses 17 may be formed between the preliminary horizontal layers 14A. Each of the upper and lower surfaces of the preliminary horizontal layers 14A may be flat.

From the perspective of a top view, the preliminary horizontal layers 14A may have a cross shape, and the side surfaces of the preliminary horizontal layers 14A may have a bent shape or a round shape.

After the preliminary horizontal layers 14A are formed, the first and second vertical openings 15 and 16 may be expanded. The preliminary horizontal layers 14A may be spaced apart from each other by the first and second vertical openings 15 and 16 in the second direction D2. The preliminary horizontal layers 14A may have a shape in which a plurality of cross shapes are merged in the third direction D3.

While the preliminary horizontal layers 14A are formed, the surface of the lower structure 11 may be recessed to a predetermined depth (see a reference numeral '11A'). As a result, the bottom depth of the first and second vertical openings 15 and 16 may be increased.

The first vertical openings 15 and the second vertical openings 16 may be alternately disposed between the preliminary horizontal layers 14A in the second direction D2.

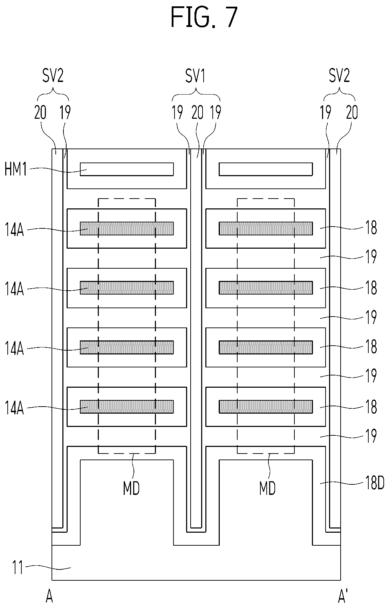

Referring to FIG. 7, first dielectric layers 18 fully covering the preliminary horizontal layers 14A may be formed. The first dielectric layers 18 may include silicon nitride. The first dielectric layers 18 may fully cover the upper surfaces, lower surfaces, and side surfaces of the preliminary horizontal layers 14A.

While the first dielectric layers 18 are formed, a dummy dielectric layer 18D may be formed on the surface of the lower structure 11. A portion of the first dielectric layers 18 may fully cover the upper surfaces, lower surfaces, and side surfaces of the hard mask layer pattern HM1.

A second dielectric layer 19 may be formed over the first dielectric layers 18. The second dielectric layer 19 may fill between the vertically neighboring first dielectric layers 18. The second dielectric layer 19 may include silicon oxide. Portions of the second dielectric layer 19 may be formed conformally on the surfaces of the first and second vertical openings 15 and 16. The horizontal recesses (see a reference numeral '17' in FIG. 6) may be filled with the first dielectric layer 18 and the second dielectric layer 19.

A sacrificial pillar 20 may be formed over the second dielectric layer 19 disposed in the first and second vertical openings 15 and 16. The sacrificial pillar 20 may be a sacrificial material and may include amorphous carbon. According to another embodiment of the present disclosure, a pillar capping layer may be further formed over the sacrificial pillar 20. The pillar capping layer may include a metal-based material. The pillar capping layer may include titanium nitride. Forming the sacrificial pillar 20 may include depositing a sacrificial material and planarizing the sacrificial material. The planarization process for forming the sacrificial pillar 20 may be performed until the first dielectric layer 18 of the uppermost level is exposed. Subsequently, the second dielectric layers 19 of the uppermost level may also be planarized until the first dielectric layer 18 of the uppermost level is exposed. The sacrificial pillar 20 may not be formed between the vertically stacked first dielectric layers 18.

The second dielectric layer 19 and the sacrificial pillar 20 may form first and second sacrificial pillar structures SV1 and SV2 that fill the first and second vertical openings 15 and 16. The first sacrificial pillar structure SV1 may fill the first vertical openings 15, and the second sacrificial pillar structure SV2 may fill the second vertical openings 16. According to another embodiment of the present disclosure, the first and second sacrificial pillar structures SV1 and SV2 may include a dielectric material, a carbon-containing material, a metal-based material, or a combination thereof. According to another embodiment of the present disclosure, the first and second sacrificial pillar structures SV1 and SV2 may include silicon oxide, silicon nitride, titanium nitride, amorphous carbon, or a combination thereof. From the perspective of a top view, the first sacrificial pillar structure SV1 and the second sacrificial pillar structure SV2 may be hole-type sacrificial pillars. According to another embodiment of the present disclosure, portions of the first dielectric layer 18 may be formed conformally on the surfaces of the first and second vertical openings 15 and 16, thereby further including portions of the first dielectric layer 18 in the first and second sacrificial pillar structures SV1 and SV2.

As described above, by forming the preliminary horizontal layers 14A, the first dielectric layers 18, and the second dielectric layers 19, a cell mold structure MD may be formed. The cell mold structure MD may include a plurality of cell molds. Each cell mold may include a plurality of mold layers. The mold layers may refer to preliminary horizontal layers 14A, the first dielectric layers 18 and the second dielectric layers 19. Each of the cell molds may include an ONSN (Oxide-Nitride-Silicon-Nitride) stack. Here, the ONSN stack may refer to a structure in which silicon oxide, a first silicon nitride, a monocrystalline silicon layer, and a second silicon nitride are sequentially stacked. The silicon oxide may correspond to the second dielectric layers 19, and the first and second silicon nitrides may correspond to the first dielectric layers 18, and the monocrystalline silicon layer may correspond to the preliminary horizontal layers 14A. A cell mold structure MD including a plurality of cell molds may be referred to as a vertical stack. From another perspective, the cell mold structure may include an ONSNO (Oxide-Nitride-Silicon-Nitride-Oxide) stack. Here, the ONSNO stack may refer to a structure in which a first silicon oxide, a first silicon nitride, a monocrystalline silicon layer, a second silicon nitride, and a second silicon oxide are sequentially stacked.

As described above, through a series of the processes according to FIGS. 4 to 7, the sub-stacks of the stack body SB may be replaced with cell molds. The first layers 12A, the second layers 13, and the third layers 12B of the stack body SB may be replaced with the first dielectric layers 18 and the second dielectric layers 19 of the cell mold structure MD. The fourth layers 14 of the stack body SB may become the preliminary horizontal layer 14A of the cell mold structure MD through a recess process. The first dielectric layers 18 may be referred to as a trimming target layer.

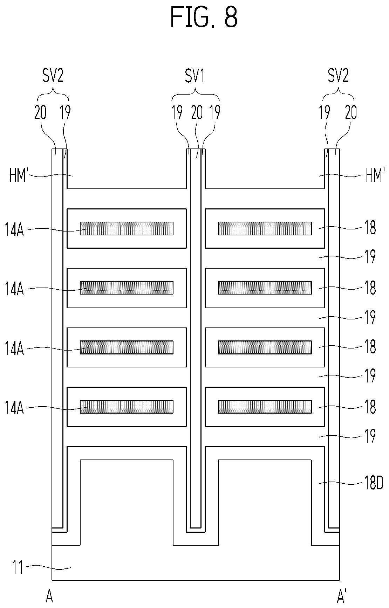

Referring to FIG. 8, forming a hard mask layer level opening HM' includes removing the hard mask layer pattern HM1 and the first dielectric layer 18 of the uppermost level.

Although not illustrated, before the hard mask layer level opening HM' is formed, cell isolation layers ISOA and ISOB as illustrated in FIG. 2 may be formed. Also, before the cell isolation layers ISOA and ISOB are formed, a trimming process of the preliminary horizontal layers 14A may be performed. By the trimming process, the preliminary horizontal layers 14A may have a shape in which cross shapes are individually separated in the third direction D3.

For example, after the cell mold structure is formed, forming cell isolation openings, trimming the preliminary horizontal layers 14A through the cell isolation openings, and forming cell isolation layers filling the cell isolation openings may be performed sequentially. Also, before the cell mold structure is formed, forming sacrificial isolation openings in the stack body, and forming sacrificial isolation layers filling the sacrificial isolation openings may be performed. The sacrificial isolation layers may be removed to form the cell isolation openings.

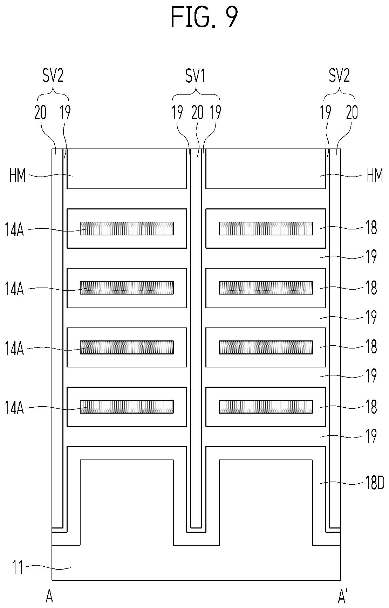

Referring to FIG. 9, the hard mask layer level opening HM' may be filled with top dielectric layers HM. The top dielectric layers HM may include silicon oxide.

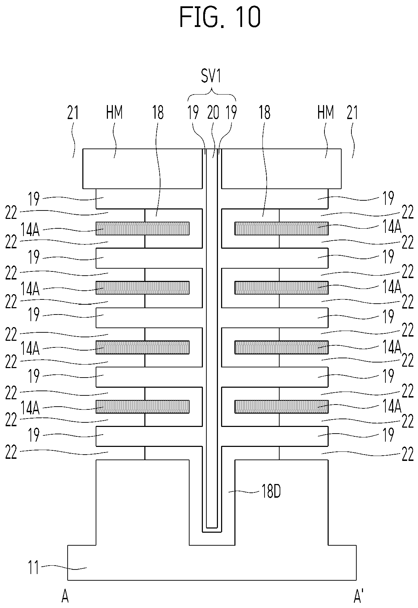

Referring to FIG. 10, sacrificial vertical openings 21 may be formed by removing the second sacrificial pillar structures SV2. To form the sacrificial vertical openings 21, the second dielectric layer 19 and the sacrificial pillar 20 of the second sacrificial pillar structures SV2 may be selectively etched.

The second dielectric layers 19 may be horizontally recessed through the sacrificial vertical openings 21. As a result, the first dielectric layers 18 and the dummy dielectric layer 18D may be exposed through the sacrificial vertical openings 21.

The first dielectric layers 18 and the dummy dielectric layer 18D may be selectively recessed horizontally. As a result, dielectric layer level recesses 22 may be formed, and portions of the preliminary horizontal layers 14A may be exposed by the dielectric layer level recesses 22.

The amount of recessing of the first dielectric layers 18 may be greater than the amount of recessing of the second dielectric layers 19.

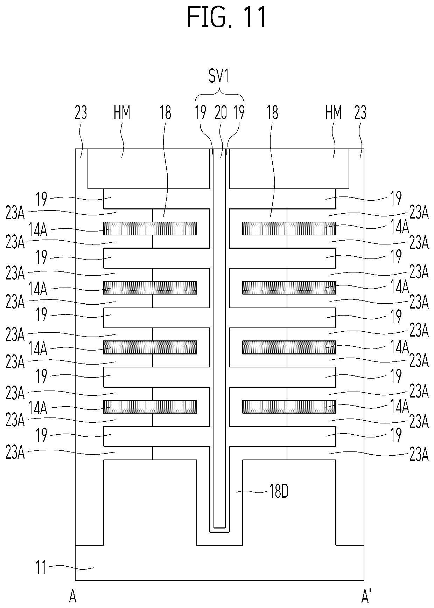

Referring to FIG. 11, vertical sacrificial structures 23 may be formed to fill the dielectric layer level recesses 22 and the sacrificial vertical openings 21. The vertical sacrificial structures 23 may include a dielectric material such as, for example, silicon oxide, silicon nitride, titanium nitride, amorphous carbon, or a combination thereof. Each of the vertical sacrificial structures 23 may include expanded portions 23A that fill the dielectric layer level recesses 22.

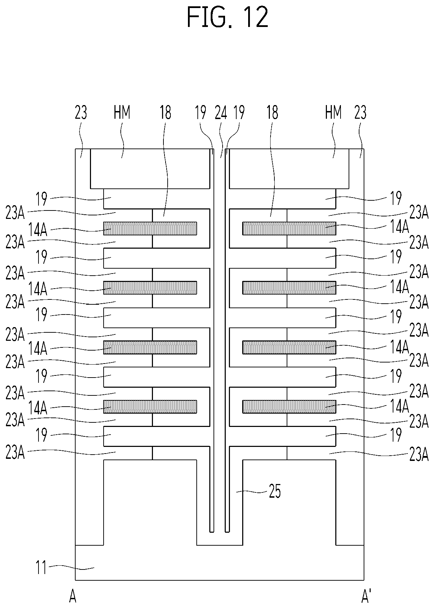

Referring to FIG. 12, forming the vertical level path 24 includes removing the sacrificial pillar 20 of the first sacrificial pillar structure SV1.

Forming a lower level gap 25 includes removing the dummy dielectric layer 18D below the vertical level path 24. Before the dummy dielectric layer 18D is removed, the bottom surface of the second dielectric layer 19 of the lowermost level may be cut.

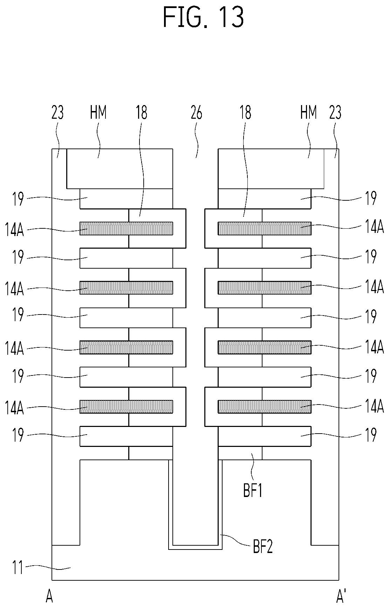

Referring to FIG. 13, the second dielectric layers 19 may be cut to form a first hole-type vertical opening 26.

A first passivation layer BF1 may be formed to fill the lower level gap 25. The first passivation layer BF1 may include silicon oxide and may be formed by first depositing silicon oxide to fill the lower level gap 25 and then etching the silicon oxide.

A second passivation layer BF2 may be formed in the lower region of the first hole-type vertical opening 26. For example, the surface of the lower structure 11 may be oxidized to form the second passivation layer BF2.

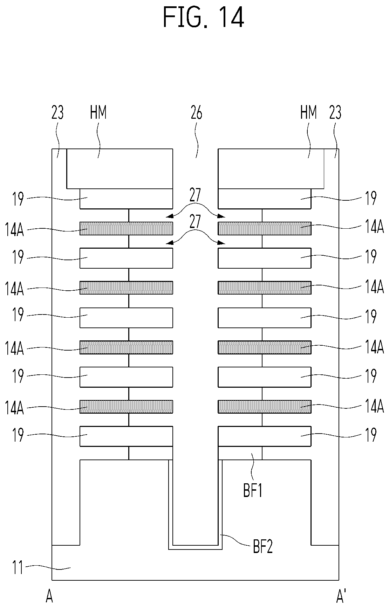

Referring to FIG. 14, the first dielectric layers 18 may be removed to form horizontal level recesses 27 that extend from the first hole-type vertical opening 26. Portions of the preliminary horizontal layers 14A may be exposed by the horizontal level recesses 27. One preliminary horizontal layer 14A may be partially exposed by a pair of horizontal level recesses 27. The horizontal level recesses 27 may be disposed between the second dielectric layer 19 and the preliminary horizontal layers 14A. Two horizontal level recesses 27 may face each other with one preliminary horizontal layer 14A therebetween.

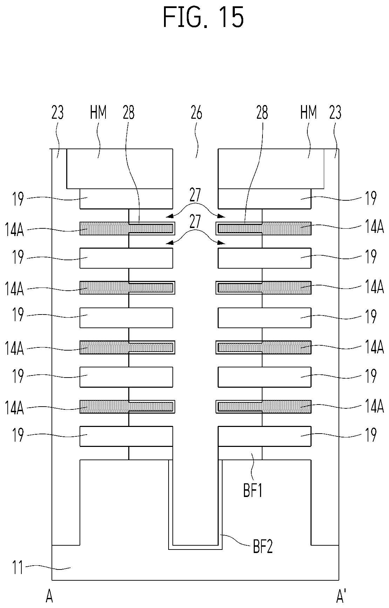

Referring to FIG. 15, an inter-level dielectric layer 28 may be formed over the exposed portions of the preliminary horizontal layers 14A. The inter-level dielectric layer 28 may be referred to as a gate dielectric layer. The inter-level dielectric layer 28 may correspond to the inter-level dielectric layer GD as illustrated in FIGS. 1A to 1C. The inter-level dielectric layer 28 may be formed by oxidizing the surfaces of the preliminary horizontal layers 14A. According to another embodiment of the present disclosure, an inter-level dielectric layer 28 may be formed by a deposition process of silicon oxide.

The inter-level dielectric layer 28 may include silicon oxide, silicon nitride, a metal oxide, a metal oxynitride, a metal silicate, a high-k material, a ferroelectric material, an anti-ferroelectric material, or a combination thereof. The inter-level dielectric layer 28 may include SiO₂, Si₃N₄, HfO₂, Al₂O₃, ZrO₂, AlON, HfON, HfSiO, HfSiON, or a combination thereof.

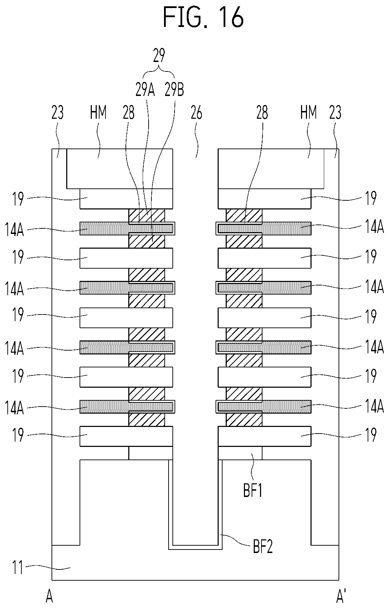

Referring to FIG. 16, a horizontal conductive line 29 filling the horizontal level recesses 27 may be formed over the inter-level dielectric layer 28, for example, by depositing a conductive material filling the horizontal level recesses 27 over the inter-level dielectric layer 28 and etching back the conductive material. The horizontal conductive line 29 may include a pair of first and second horizontal conductive lines 29A and 29B that are facing each other with the preliminary horizontal layer 14A therebetween. The first and second horizontal conductive lines 29A and 29B may include a metal-based material, a semiconductor material, or a combination thereof. The first and second horizontal conductive lines 29A and 29B may include titanium nitride, tungsten, polysilicon, or a combination thereof. For example, the first and second horizontal conductive lines 29A and 29B may include a TiN/W stack in which titanium nitride and tungsten are sequentially stacked. The first and second horizontal conductive lines 29A and 29B may include an N-type work function material or a P-type work function material. The N-type work function material may have a low work function of approximately 4.5 eV or less, and the P-type work function material may have a high work function of approximately 4.5 eV or more.

The horizontal conductive lines 29 may correspond to the second conductive lines DWL as illustrated in FIGS. 1A to 1C, and the first horizontal conductive line 29A and the second horizontal conductive lines 29B may correspond to the upper horizontal lines G1 and the lower horizontal lines G2. As illustrated in FIGS. 1A to 1C, each of the first and second horizontal conductive lines 29A and 29B may have a cross shape, and may include a channel overlapping portion WLP and a channel non-overlapping portion NOL.

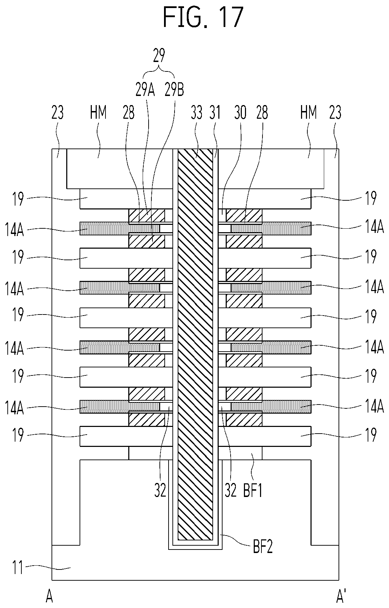

Referring to FIG. 17, a first capping layer 30 may be formed on one side surface of each of the horizontal conductive lines 29. The first capping layers 30 may include silicon oxide, silicon nitride, silicon carbon oxide, an embedded air gap, or a combination thereof. A process of depositing a capping material and an etch-back process may be performed to form the first capping layer 30. While the first capping layer 30 is formed or after the first capping layer 30 is formed, a portion of the inter-level dielectric layer 28 may be removed to expose a first edge portion of each of the preliminary horizontal layers 14A.

A vertical conductive line 33 coupled to the first edge portion of each of the preliminary horizontal layers 14A may be formed. The vertical conductive line 33 may fill the first hole-type vertical opening 26. The vertical conductive line 33 may be commonly coupled to the preliminary horizontal layers 14A that are disposed in the first direction D1. The vertical conductive lines 33 may include titanium nitride, tungsten, or a combination thereof. The vertical conductive line 33 may be referred to as a bit line or a vertical bit line.

Before the vertical conductive line 33 is formed, a first doped region 32 and a first contact node 31 may be formed. A first doped region 32 may be formed in the first edge portions of each of the preliminary horizontal layers 14A. Forming the first doped regions 32 may include depositing polysilicon that is doped with an N-type impurity, performing a heat treatment, and removing the doped polysilicon. The first doped regions 32 may include an impurity diffused from the doped polysilicon. According to another embodiment of the present disclosure, the first doped regions 32 may be formed by a process of doping an impurity.

The first contact node 31 may include doped polysilicon. The first doped region 32 may include an impurity diffused from the first contact node 31. A metal silicide layer may be further formed between the vertical conductive line 33 and the first contact node 31.

The vertical conductive line 33 may correspond to the first conductive line BL as illustrated in FIGS. 1A to 1C. The first contact node 31 may correspond to the first contact node BLC as illustrated in FIGS. 1A to 1C, and the first doped region 32 may correspond to the first doped region SR as illustrated in FIGS. 1A to 1C.

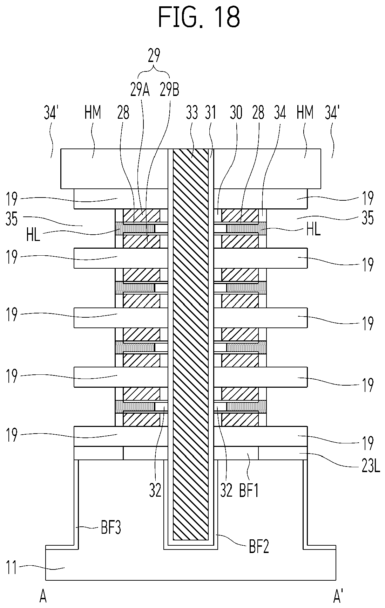

Referring to FIG. 18, a portion of the vertical sacrificial structure 23 may be removed to form second hole-type vertical openings 34'. One side surface, that is, a second edge portion, of the preliminary horizontal layers 14A may be exposed by the second hole-type vertical openings 34'.

By removing the portion of the vertical sacrificial structure 23, a lowermost-level dielectric layer 23L may be formed on the side surface of the first passivation layers BF1. According to another embodiment of the present disclosure, the lowermost-level dielectric layer 23L may not remain.

A third passivation layer BF3 may be formed on the surface of the lower structure 11. The third passivation layer BF3 may include silicon oxide and may be formed, for example, by an oxidation process.

The second edge portion of the preliminary horizontal layers 14A may be horizontally recessed in the second direction D2, and as a result, the horizontal layers HL may be formed.

The expanded portions (see reference numeral '23A' in FIG. 12) of the vertical sacrificial structure 23 may be selectively recessed to form second capping layers 34. The second capping layers 34 may include silicon oxide, silicon nitride, or a combination thereof.

After the second capping layers 34 are formed, storage openings 35 extending horizontally from the second hole-type vertical openings 34' may be formed. The storage openings 35 may be referred to as capacitor openings.

The horizontal layers HL may include first and second edges. The first edge refers to a portion that is coupled to the first contact node 31 and the vertical conductive line 33. The second edge refers to a portion that is exposed by the storage openings 35.

The storage openings 35 may be disposed between the vertically neighboring second dielectric layers 19. The second capping layers 34 may be disposed in the lower and upper portions of the horizontal layers HL, respectively.

As described above, forming the horizontal layers HL and the storage openings 35 may include forming the second hole-type vertical openings 34', recessing the preliminary horizontal layers 14A, and forming the second capping layers 34.

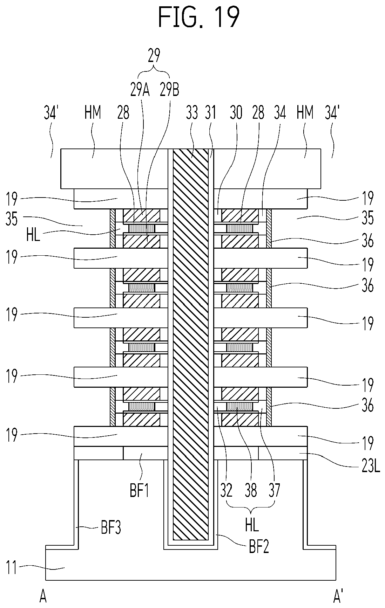

Referring to FIG. 19, second doped regions 37 may be formed in the second edges of the horizontal layers HL, respectively. Forming the second doped regions 37 may include depositing polysilicon that is doped with an N-type impurity, performing a heat treatment, and removing the doped polysilicon. The second doped regions 37 may include an impurity that is diffused from the doped polysilicon. According to another embodiment of the present disclosure, after the heat treatment, the doped polysilicon may remain.

Second contact nodes 36 may be formed over the second edges of the horizontal layers HL. The second contact nodes 36 may include doped polysilicon. The second doped regions 37 may include an impurity diffused from the second contact nodes 36.

Each horizontal layer HL may include the first doped region 32, the second doped region 37, and a channel 38 that are disposed horizontally in the second direction D2. The channels 38 may be defined between the first doped regions 32 and the second doped regions 37. The channels 38 may vertically overlap with the horizontal conductive lines 29. As illustrated in FIGS. 1A to 1C, the horizontal layers HL may have a cross shape, and the channels 38 may also have a cross shape.

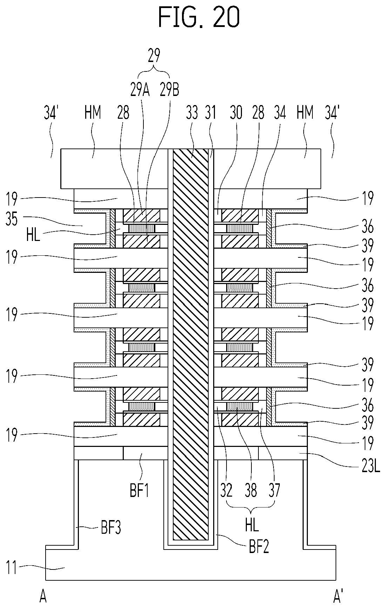

Referring to FIG. 20, first electrodes 39 of the data storage element may be formed over the second contact nodes 36. The first electrodes 39 may have a horizontally oriented cylindrical shape and may be respectively disposed in the storage openings 35. The first electrodes 39 neighboring in the second direction D2 may be spaced apart from each other by the second hole-type vertical openings 34'.

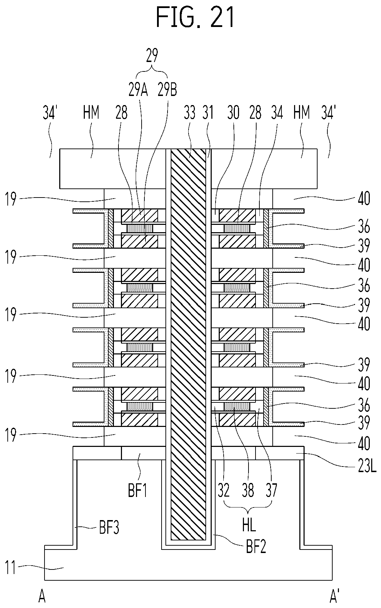

Referring to FIG. 21, the second dielectric layers 19 may be horizontally recessed (see a reference numeral '40'). As a result, the outer walls of the first electrodes 39 may be exposed. The recessed second dielectric layers 19 may correspond to the inter-cell dielectric layer IL as illustrated in FIG. 3B.

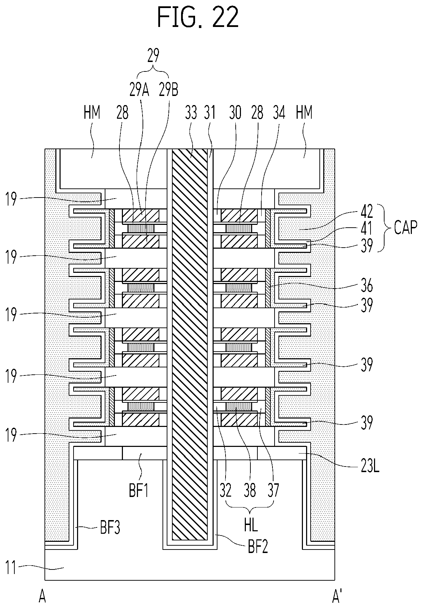

Referring to FIG. 22, a dielectric layer 41 may be formed conformally over the first electrodes 39 and a second electrode 42 may be sequentially formed over the first dielectric layer 41. The first electrode 39, the dielectric layer 41 and the second electrode 42 may become a data storage element CAP.

The first electrode 39 may include an inner space and a plurality of outer surfaces, and the inner space of the first electrode 39 may include a plurality of inner surfaces. The outer surfaces of the first electrode 39 may include a vertical outer surface and a plurality of horizontal outer surfaces. The inner space of the first electrode 39 may be a three-dimensional space. The dielectric layer 41 may conformally cover the inner and outer surfaces of the first electrode 39. The second electrode 42 may be disposed in the inner space of the first electrode 39 over the dielectric layer 41. Some of the outer surfaces of the first electrode 39 may be coupled to the horizontal layer HL.

The first electrode 39 may have a cylindrical shape. The cylindrical shape of the first electrode 39 may include cylindrical inner surfaces and cylindrical outer surfaces. The dielectric layer 41 and the second electrode 42 may be disposed on the cylindrical inner surfaces of the first electrode 39.

The first electrode 39 and the second electrode 42 may include a metal, a noble metal, a metal nitride, a conductive metal oxide, a conductive noble metal oxide, a metal carbide, a metal silicide, or a combination thereof. For example, the first electrode 39 and the second electrode 42 may include titanium (Ti), titanium nitride (TiN), tantalum (Ta), tantalum nitride (TaN), titanium silicon nitride (TiSiN), tungsten (W), tungsten nitride (WN), ruthenium (Ru), ruthenium oxide (RuO₂), iridium (Ir), iridium oxide (IrO₂), platinum (Pt), molybdenum (Mo), molybdenum oxide (MoO), a titanium nitride/tungsten (TiN/W) stack, a tungsten nitride/tungsten (WN/W) stack, a titanium silicon nitride/titanium nitride (TiSiN/TiN) stack, or a combination thereof. The second electrode 42 may include a combination of a metal-based material and a silicon-based material. For example, the second electrode 42 may be a stack (TiN/SiGe/WN) of titanium nitride/silicon germanium/tungsten nitride. In the titanium nitride/silicon germanium/tungsten nitride (TiN/SiGe/WN) stack, silicon germanium may be a gap-fill material that fills the inner space of the first electrode 39, and titanium nitride (TiN) may serve as the second electrode 42 of the data storage element CAP, and tungsten nitride may be a low-resistance material.

The dielectric layer 41 may be referred to as a capacitor dielectric layer or a memory layer. The dielectric layer 41 may include silicon oxide, silicon nitride, a high-k material, a perovskite material, a ferroelectric material, an antiferroelectric material, or a combination thereof. The dielectric layer 41 may include a high-k material, such as hafnium oxide (HfO₂), zirconium oxide (ZrO₂), aluminum oxide (Al₂O₃), lanthanum oxide (La₂O₃), titanium oxide (TiO₂), tantalum oxide (Ta₂O₅), niobium oxide (Nb₂O₅) or strontium titanium oxide (SrTiOs). The dielectric layer 41 may include a ZA (ZrO₂/Al₂O₃) stack, a ZAZ (ZrO₂/Al₂O₃/ZrO₂) stack, a ZAZA (ZrO₂/Al₂O₃/ZrO₂/Al₂O₃) stack, a ZAZAZ (ZrO₂/Al₂O₃/ZrO₂/Al₂O₃/ZrO₂) stack, a HA (HfO₂/Al₂O₃) stack, a HAH (HfO₂/Al₂O₃/HfO₂) stack, a HAHA (HfO₂/Al₂O₃/HfO₂/Al₂O₃) stack, or a HAHAH (HfO₂/Al₂O₃/HfO₂/Al₂O₃/HfO₂) stack.

According to another embodiment of the present disclosure, an interface control layer for reducing leakage current may be further formed between the first electrode 39 and the dielectric layer 41. The interface control layer may include titanium oxide (TiO₂), tantalum oxide (Ta₂O₅), niobium oxide (Nb₂O₅), niobium nitride (NbN), or a combination thereof. The interface control layer may also be formed between the second electrode 42 and the dielectric layer 41.

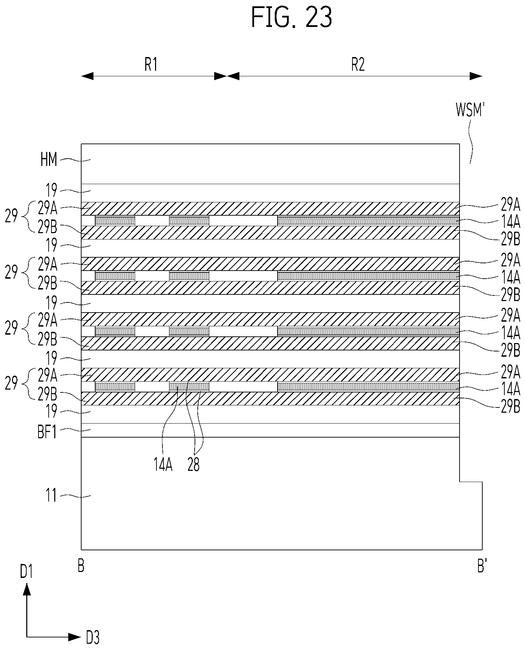

FIGS. 23 to 31 illustrate a method for forming a connection portion in accordance with embodiments of the present disclosure. FIGS. 23 to 31 illustrate a method of forming a connection portion taken along the line B-B' shown in FIG. 2 in accordance with embodiments of the present disclosure.

Referring to FIGS. 4 to 17, after the horizontal conductive lines 29 and the vertical conductive lines 33 are formed, a connection portion may be formed at one-side edge portion of the horizontal conductive lines 29.

Referring to FIG. 23, the horizontal conductive lines 29 may each include a pair of a first horizontal conductive line 29A and a second horizontal conductive line 29B. A plurality of horizontal conductive lines DWL may be stacked in the first direction D1. The preliminary horizontal layer 14A and the inter-level dielectric layer 28 may be formed in the first region R1 and the second region R2, respectively. The second dielectric layers 19 may be formed between the horizontal conductive lines 29.

The horizontal conductive lines 29 and the second dielectric layers 19 may be etched to form a pad separation slit WSM' in the second region R2.

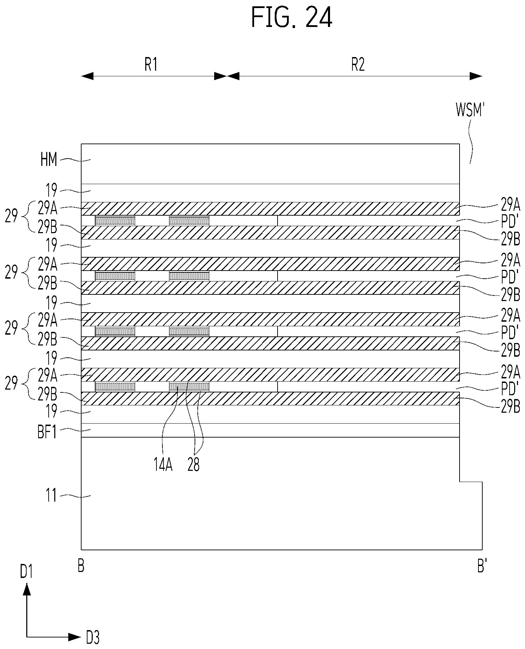

Referring to FIG. 24, the inter-level dielectric layer 28 and the preliminary horizontal layers 14A may be removed through the pad separation slit WSM' in the second region R2. As a result, pad-type recesses PD' may be formed between the first horizontal conductive line 29A and the second horizontal conductive line 29B.

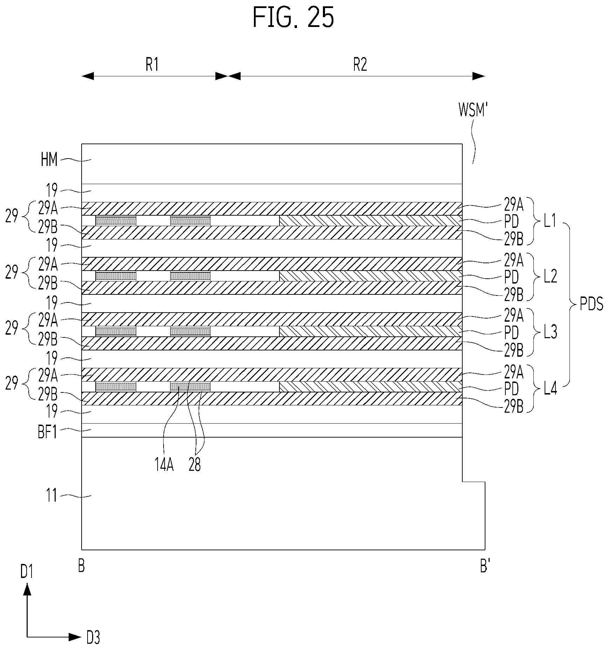

Referring to FIG. 25, pads PD may be formed to fill the pad-type recesses PD'.

The horizontal conductive lines 29 may include a plurality of levels L1, L2, L3 and L4. For example, the first level L1 may refer to the horizontal conductive line 29 of the uppermost level, and the fourth level L4 may refer to the horizontal conductive line 29 of the lowermost level. The second level L2 may be a lower level than the first level L1, and the third level L3 may be a lower level than the second level L2. The fourth level L4 may be a lower level than the third level L3.

The fourth level L4, the third level L3, the second level L2, and the first level L1 may be stacked in the mentioned order in the first direction D1.

Each of the horizontal conductive lines 29 of the levels L1 to L4 may include a pair of a first horizontal conductive line 29A and a second horizontal conductive line 29B. The horizontal conductive lines 29 may be disposed in the first region R1, and portions of the horizontal conductive lines 29 may extend to the second region R2. Portions of the horizontal conductive lines 29 disposed in the second region R2 may be simply referred to as an edge portion or a connection portion PDS.

The connection portion PDS of the horizontal conductive lines 29 may include a plurality of levels L1, L2, L3 and L4. Each of the horizontal conductive lines 29 of the levels L1 to L4 in the connection portion PDS may include a pair of a first horizontal conductive line 29A and a second horizontal conductive line 29B. In the connection portion PDS, the levels L1 to L4 may further include the pads PD. Each of the pads PD may be disposed between the first horizontal conductive line 29A and the second horizontal conductive line 29B. Each of the pads PD may be electrically connected to the first horizontal conductive line 29A and the second horizontal conductive line 29B.

The horizontal lengths of the pads PD in the third direction D3 may be the same. The pads PD and the horizontal layers 14A may be spaced apart from each other. The pads PD may not be disposed in the first region R1.

The pads PD, the first horizontal conductive lines 29A, and the second horizontal conductive lines 29B may include the same material. The pads PD, the first horizontal conductive line 29A, and the second horizontal conductive lines 29B may include a metal-based material. For example, the pads PD, the first horizontal conductive lines 29A, and the second horizontal conductive lines 29B may include titanium nitride, tungsten, or a combination thereof.

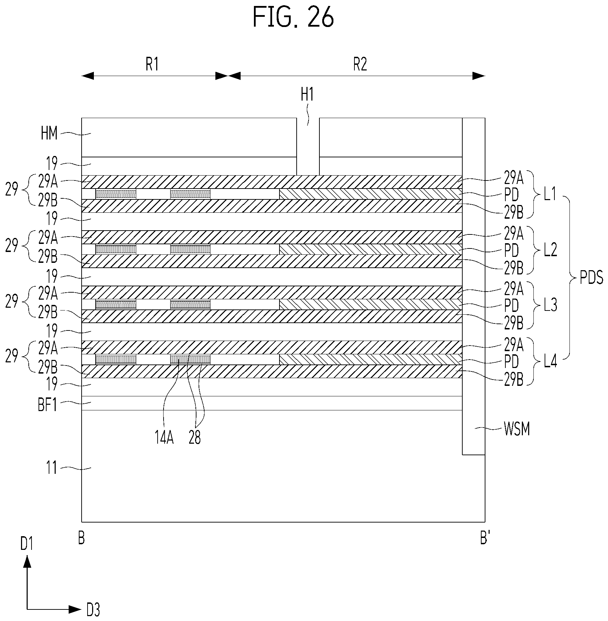

Subsequently, as illustrated in FIGS. 26 to 29, a plurality of contact holes H1, H2, H3 and H4 may be sequentially formed in the second region R2.

Referring to FIG. 26, the hard mask layer pattern HM and the second dielectric layer 19 of the uppermost level may be etched to form the first contact hole H1. The first contact hole H1 may expose the upper surface of the horizontal conductive line 29 at the first level L1, that is, the upper surface of the first horizontal conductive line 29A of the first level L1.

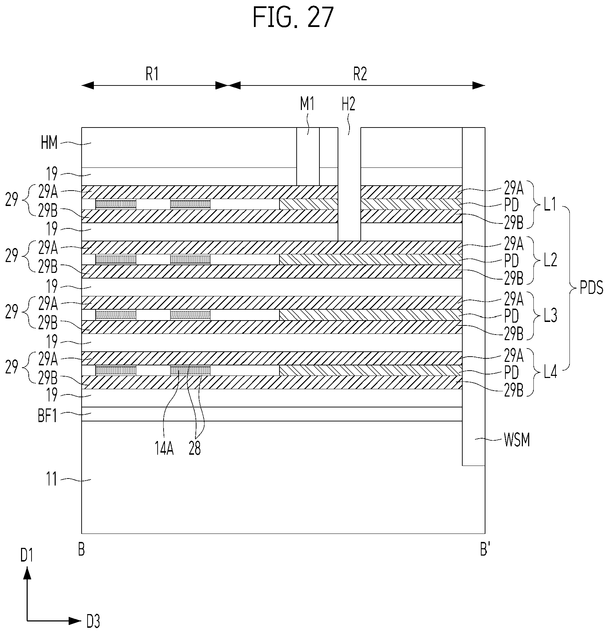

Referring to FIG. 27, after the first contact hole H1 is masked M1, the hard mask layer pattern HM and the horizontal conductive line DWL of the first level may be etched to form the second contact hole H2. Also, for forming the second contact hole H2, the second dielectric layer 19 of the uppermost level, and the second dielectric layer 19 between the first level L1 and the second level L2 may be etched. The second contact hole H2 may expose the upper surface of the horizontal conductive line 29 of the second level L2, that is, the upper surface of the first horizontal conductive line 29A of the second level L2.

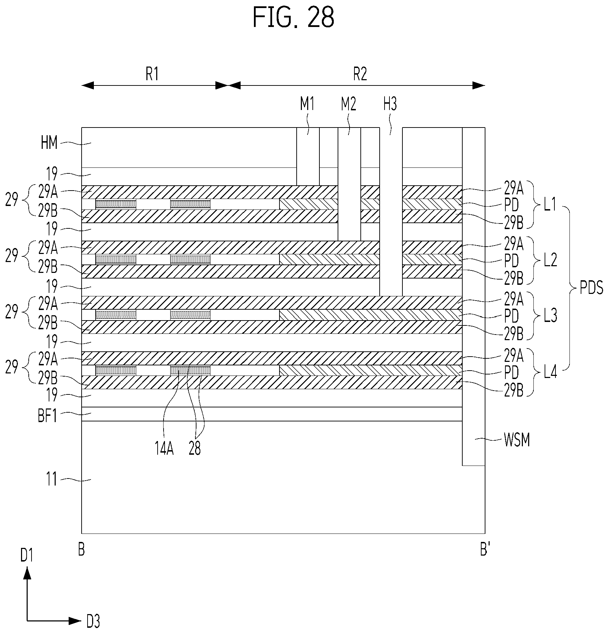

Referring to FIG. 28, after the first and second contact holes H1 and H2 are masked M1 and M2, respectively, the hard mask layer pattern HM, the horizontal conductive line 29 of the first level, and the horizontal conductive line 29 of the second level may be etched to form the third contact hole H3. Also, to form the third contact hole H3, the second dielectric layer 19 of the uppermost level, the second dielectric layer 19 between the first level L1 and the second level L2, and the second dielectric layer 19 between the second level L2 and the third level L3 may be etched. The third contact hole H3 may expose the upper surface of the horizontal conductive line 29 of the third level L3, that is, the upper surface of the first horizontal conductive line 29A of the third level.

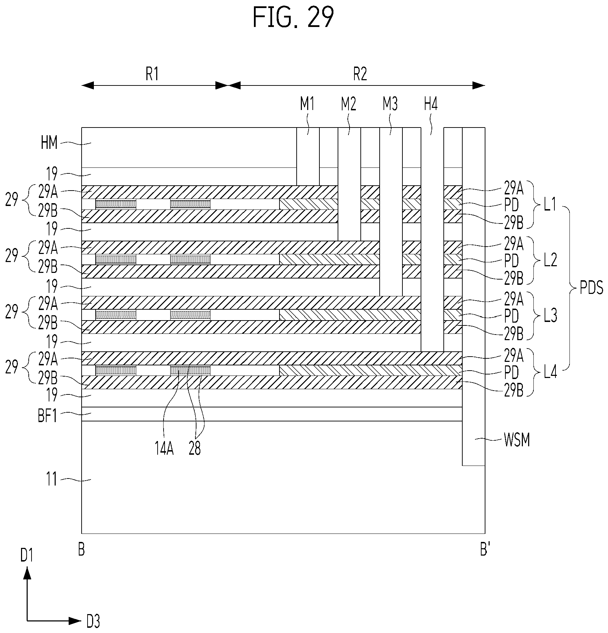

Referring to FIG. 29, after the first, second, and third contact holes H1, H2 and H3 are masked M1, M2 and M3, respectively, the hard mask layer pattern HM, the horizontal conductive line 29 of the first level, the horizontal conductive line 29 of the second level, and the horizontal conductive line 29 of the third level may be etched to form the fourth contact hole H4. Also, for forming the fourth contact hole H4, the second dielectric layer 19 of the uppermost level, the second dielectric layer 19 between the first level L1 and the second level L2, the second dielectric layer 19 between the second level L2 and the third level L3, and the second dielectric layer 19 between the third level L3 and the fourth level L4 may be etched. The fourth contact hole H4 may expose the upper surface of the horizontal conductive line 29 of the fourth level L4, that is, the upper surface of the first horizontal conductive line 29A of the fourth level.

As described above, after the first contact hole H1 is formed, for forming the second contact hole H2, the first contact hole H1 is masked M1. Likewise, when the third contact hole H3 is formed, the first and second contact holes H1 and H2 are masked M1 and M2 and when the fourth contact hole H4 is formed, the first, second, and third contact holes H1, H2 and H3 are masked M1, M2 and M3.

Through a series of the processes for forming the contact holes described above, the first to fourth contact holes H1, H2, H3, and H4 may be sequentially formed. Hence, the first contact hole H1 may be shallower than the second contact hole H2, the second contact hole H2 may be shallower than the third contact hole H3, and the third contact hole H3 may be shallower than the fourth contact hole H4. The depth of the contact holes H1 to H4 may gradually become shallower in a direction that the horizontal conductive lines 29 are stacked, that is, in the first direction D1.

According to another embodiment of the present disclosure, the contact holes H1, H2, H3 and H4 may be formed sequentially, starting from the deepest contact hole. For example, the fourth contact hole H4, the third contact hole H3, the second contact hole H2, and the first contact hole H1 may be formed in the mentioned order. Hence, the order of forming the fourth contact hole H4, the third contact hole H3, the second contact hole H2, and the first contact hole H1 may be modified.

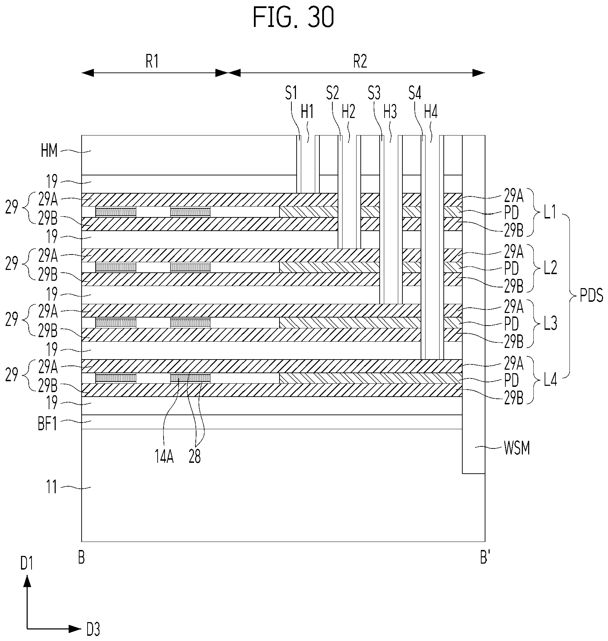

Referring to FIG. 30, contact spacers S1 to S4 may be formed on the sidewalls of the first contact hole H1, the second contact hole H2, the third contact hole H3, and the fourth contact hole H4 respectively. The contact spacers S1 to S4 may be formed by depositing a dielectric material and etching the dielectric material. The contact spacers S1 to S4 may include silicon oxide, silicon nitride, or a combination thereof.

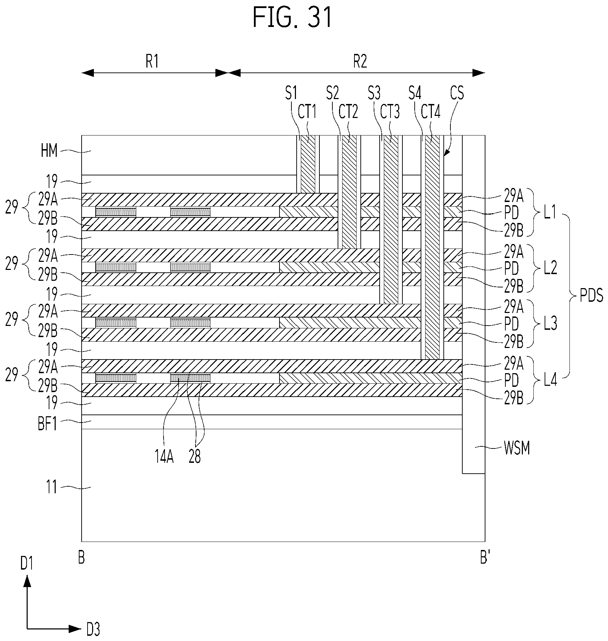

Referring to FIG. 31, contact plugs CT1 to CT4 may be formed in the first contact hole H1, the second contact hole H2, the third contact hole H3, and the fourth contact hole H4, respectively. The contact plugs CT1 to CT4 may include a metal-based material. The contact plugs CT1 to CT4 may include a structure whose height is gradually decreased in a direction that the horizontal conductive lines 29 are stacked (i.e., the first direction D1).

As described above, the second region R2 may include contact structures CS that are respectively coupled to the horizontal conductive lines 29 of the connection portion PDS. The contact structure CS may include contact plugs CT1, CT2, CT3 and CT4 and contact spacers S1, S2, S3 and S4.

The first contact plug CT1 may be electrically connected to the horizontal conductive line 29 of the first level L1. The first contact plug CT1 may be electrically connected to the first horizontal conductive line 29A of the first level L1. The second contact plug CT2 may be electrically connected to the horizontal conductive line 29 of the second level L2. The second contact plug CT2 may be electrically connected to the first horizontal conductive line 29A of the second level L2. The third contact plug CT3 may be electrically connected to the horizontal conductive line 29 of the third level L3. The third contact plug CT3 may be electrically connected to the first horizontal conductive line 29A of the third level L3. The fourth contact plug CT4 may be electrically connected to the horizontal conductive line 29 of the fourth level L4. The fourth contact plug CT4 may be electrically connected to the first horizontal conductive line 29A of the fourth level L4.

The first contact spacer S1 may be disposed on the sidewall of the first contact plug CT1, the second contact spacer S2 may be disposed on the sidewall of the second contact plug CT2, the third contact spacer S3 may be disposed on the sidewall of the third contact plug CT3, and the fourth contact spacer S4 may be disposed on the sidewall of the fourth contact plug CT4. The vertical height of the fourth contact plug CT4 may be greater than the vertical height of the third contact plug CT3, the vertical height of the third contact plug CT3 may be greater than the vertical height of the second contact plug CT2, and the vertical height of the second contact plug CT2 may be greater than the vertical height of the first contact plug CT1. Here, the vertical height may refer to the height in the first direction D1.

The fourth contact plug CT4 and the fourth contact spacer S4 may penetrate the pads PD and the first and second horizontal conductive lines 29A and 29B of the first level L1, the second level L2, and the third level L3. The fourth contact plug CT4 may be electrically disconnected from the pads PD and the first and second horizontal conductive lines 29A and 29B of the first level L1, the second level L2 and the third level L3, by the fourth contact spacer S4.

The third contact plug CT3 and the third contact spacer S3 may penetrate the pads PD and the first and second horizontal conductive lines 29A and 29B of the first level L1 and the second level L2. The third contact plug CT3 may be electrically disconnected from the pads PD and the first and second horizontal conductive lines 29A and 29B of the first level L1 and the second level L2 by the third contact spacer S3.

The second contact plug CT2 and the second contact spacer S2 may penetrate the pad PD and the first and second horizontal conductive lines 29A and 29B of the first level L1. The second contact plug CT2 and the first and second horizontal conductive lines 29A and 29B may be electrically disconnected from the pad PD of the first level L1 by the second contact spacer S2.

According to the above description, the connection portion PDS of the horizontal conductive lines 29 may have a stair-less structure. Since the connection portion PDS is formed in the stair-less structure, the occupied area (or volume) of the connection portion PDS in the second region R2 may be decreased.

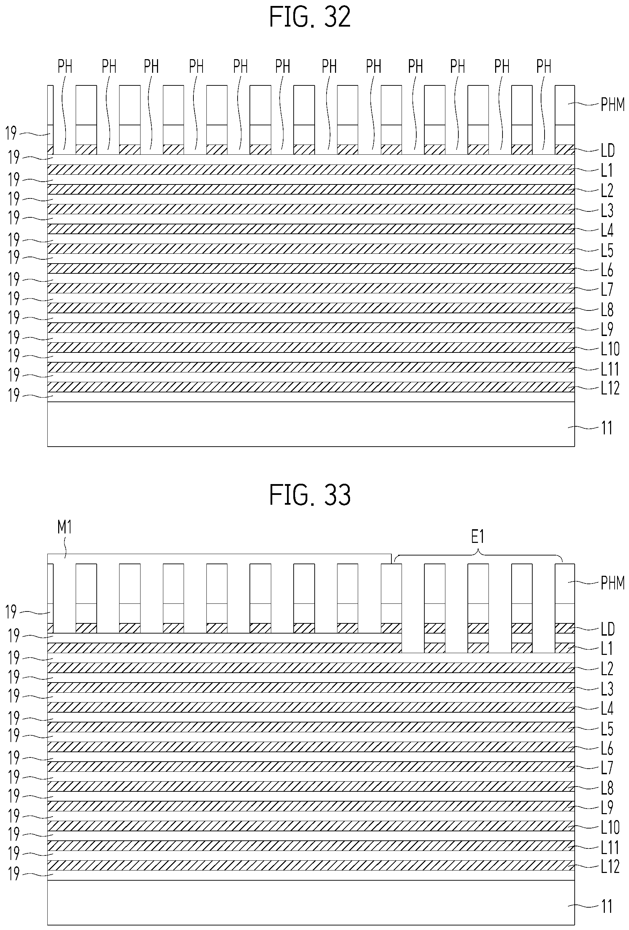

FIGS. 32 to 40 are cross-sectional views illustrating a method for fabricating a semiconductor device in accordance with another embodiment of the present disclosure. FIGS. 32 to 40 illustrate a method of etching a 12-layer connection portion.

As illustrated in FIGS. 4 to 25, after the horizontal conductive lines 29 and the vertical conductive lines 33 are formed, a connection portion PDS may be formed at one-side edge portion of the horizontal conductive lines 29.

Referring to FIG. 25, the connection portion PDS may include the horizontal conductive lines 29 and the pads PD. The pads PD may be disposed between the first horizontal conductive line 29A and the second horizontal conductive line 29B. Each of the pads PD may be electrically connected to the first horizontal conductive line 29A and the second horizontal conductive line 29B.

The connection portion PDS may include a plurality of levels L1 to L12. As illustrated in FIGS. 23 to 31, each of the levels L1 to L12 may include a stack of a first horizontal conductive line G1, a pad PD, and a second horizontal conductive line G2. The connection portion PDS may further include a dummy pad LD and a pad hard mask layer PHM. Hereinafter, for the sake of convenience in description, the stack of the first horizontal conductive line G1, the pad PD, and the second horizontal conductive line G2 of each of the levels L1 to L12 will not be illustrated.

Referring to FIG. 32, pad holes PH may be formed by etching the pad hard mask layer PHM and the dummy pad LD.

Referring to FIG. 33, a first etching E1 may be performed by using a first mask layer M1. The first etching E1 may be a single-layer etching process and a first portion of the first level L1 may be etched. Four holes may be formed at the first level L1 by the first etching E1.

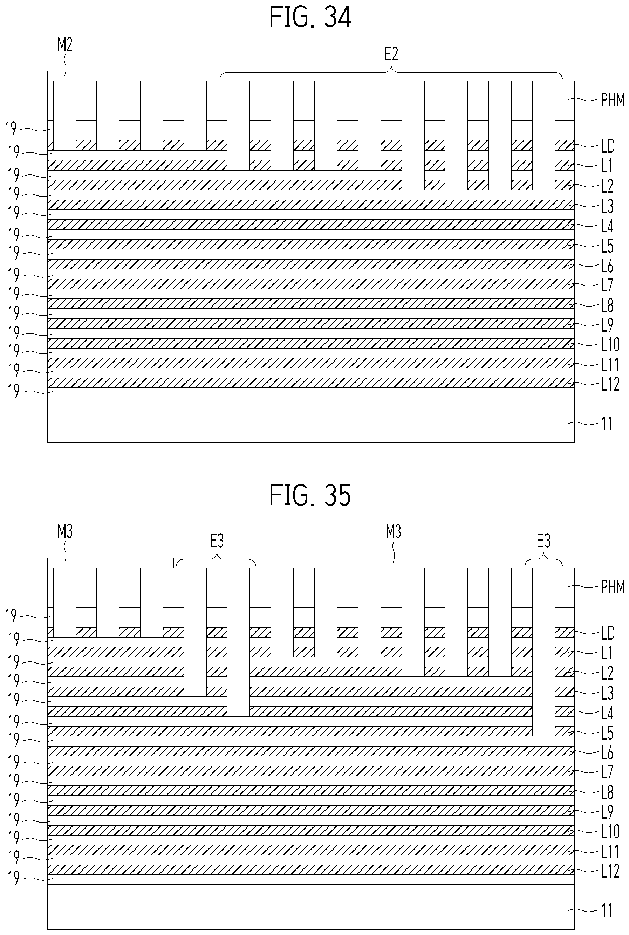

Referring to FIG. 34, a second mask layer M2 may be formed by slimming the first mask layer M1. When the first mask layer M1 includes a photoresist, the slimming process may refer to a process of reducing the width of the photoresist. A second etching E2 may be performed by using the second mask layer M2. The second etching E2 may be a single-layer etching process. A second portion of the first level L1 may be etched, and a first portion of the second level L2 may be etched. The first portion of the first level L1 and the first portion of the second level L2 may vertically overlap with each other. During the second etching E2, the first portion of the second level L2 below the first portion of the first level L1 may be etched. As a result of the second etching E2, eight holes may be formed at the first level L1, and four holes may be formed at the second level L2.

Referring to FIG. 35, a third mask layer M3 may be formed by slimming the second mask layer M2. A third etching E3 may be performed by using the third mask layer M3. The third etching E3 may be a three-layer etching process so that the third level L3, the fourth level L4, and the fifth level L5 may be etched. As a result of the third etching E3, three holes may be formed at the first level L1, the second level L2, and the third level L3, and two holes may be formed at the fourth level L4, and one hole may be formed at the fifth level L5.

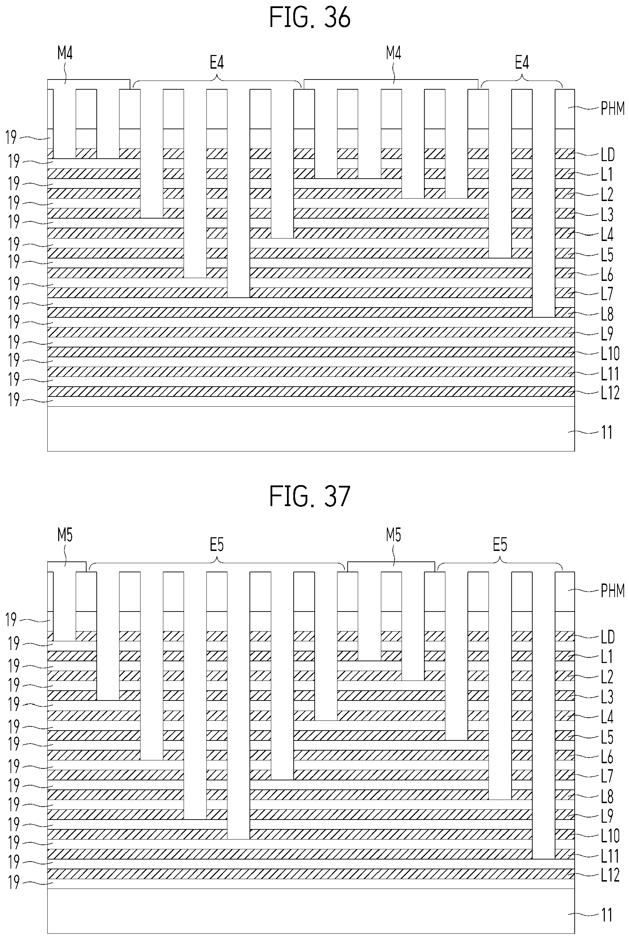

Referring to FIG. 36, a fourth mask layer M4 may be formed by slimming the third mask layer M3. A fourth etching E4 may be performed by using the fourth mask layer M4. The fourth etching E4 may be a three-layer etching process so that the sixth level L6, the seventh level L7, and the eighth level L8 may be etched. As a result of the fourth etching E4, six holes may be formed at the first level L1, the second level L2, and the third level L3, and five holes may be formed at the fourth level L4, and four holes may be formed at the fifth level L5. Three holes may be formed at the sixth level L6, and two holes may be formed at the seventh level L7, and one hole may be formed at the eighth level L8.

Referring to FIG. 37, a fifth mask layer M5 may be formed by slimming the fourth mask layer M4. A fifth etching E5 may be performed by using the fifth mask layer M5. The fifth etching E5 may be a three-layer etching process so that the ninth level L9, the 10^{th} level L10, and the 11^{th} level L11 may be etched. As a result of the fifth etching E5, nine holes may be formed at the first level L1, the second level L2, and the third level L3, and eight holes may be formed at the fourth level L4, and seven holes may be formed at the fifth level L5. Six holes may be formed at the sixth level L6, and five holes may be formed at the seventh level L7. Four holes may be formed at the eighth level L8, and three holes may be formed at the ninth level L9. Two holes may be formed at the 10^{th} level L10, and one hole may be formed at the 11^{th} level L11.

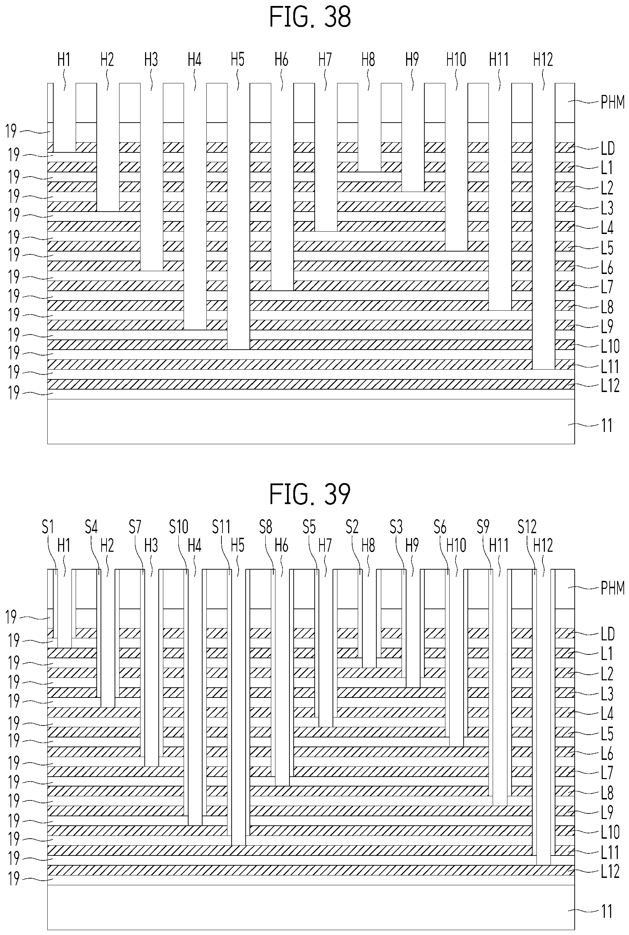

Referring to FIG. 38, the fifth mask layer M5 may be removed.

A plurality of contact holes H1 to H12, for example, 12 contact holes H1 to H12, may be formed by slimming and etching E1 to E5 the mask layers M1 to M5 as described above. The 12 contact holes H1 to H12 may have different depths. While the etchings E1 to E5 are performed, the inter-cell dielectric layers 19 may also be etched.

In another embodiment, the etching process for forming the contact holes H1 to H12 may include a one-layer etching process, a three-layer etching process, a five-layer etching process, or a combination thereof. For example, the etching process for forming the contact holes H1 to H12 may include a one-level etching of the levels L1 to L12, a three-levels etching of the levels L1 to L12, or a five levels etching of the levels L1 to L12. Since the levels L1 to L12 may include a stack of conductive layers, the etching process for forming the contact holes H1 to H12 may include a one-layer etching of the conductive layers, a three-layer etching of the conductive layers, or a five-etching of the conductive layers. The three-layer etching process is a process during which three conductive layers may be etched simultaneously, and the five-layer etching process is a process during which five conductive layers may be etched simultaneously.

Referring to FIG. 39, contact spacers S1 to S12 may be formed on the sidewalls of the contact holes H1 to H12, respectively. The contact spacers S1 to S12 may be formed by depositing a dielectric material and etching the dielectric material.

Subsequently, the inter-cell dielectric layers 19 may be etched to be self-aligned with the contact spacers S1 to S12. As a result, the depth of the contact holes H1 to H12 may become deeper. For example, the contact holes H1 to H12 may respectively expose the surfaces of the corresponding levels L1 to L12. For example, the contact hole H1 may expose the first level L1, and the contact hole H12 may expose the 12^{th} level L12.

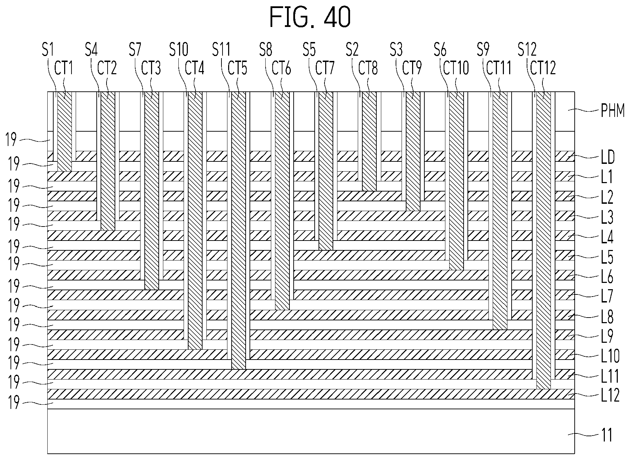

Referring to FIG. 40, contact plugs CT1 to CT12 may be formed in the contact holes H1 to H12, respectively. The contact plugs CT1 to CT12 may include a metal-based material. Among the contact plugs CT1 to CT12, the contact plug CT12 coupled to the horizontal conductive line of the lowermost level L12 may have the deepest depth. The contact plug CT12 may be referred to as a deep contact plug, and the contact plug CT12 may vertically penetrate the horizontal conductive lines at all levels L1 to L12.

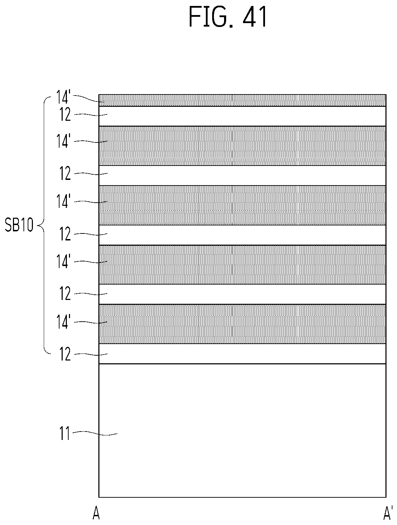

FIGS. 41 to 43 are cross-sectional views illustrating a method for fabricating a semiconductor device in accordance with another embodiment of the present disclosure.

Referring to FIG. 41, a stack body SB10 may be formed over the lower structure 11. The stack body SB10 may include an alternating stack of first semiconductor layers and second semiconductor layers. For example, the alternating stack may include a plurality of silicon germanium layers 12 and a plurality of monocrystalline silicon layers 14' that are alternately stacked by an epitaxial growth process. The silicon germanium layers 12 may be sacrificial layers, and the monocrystalline silicon layers 14' may be recess target layers. The silicon germanium layers 12 may correspond to the first layers 12A or the third layers 12B of FIG. 4, and the monocrystalline silicon layers 14' may correspond to the fourth layers 14 of FIG. 4. Unlike the stack body SB of FIG. 4, the stack body SB10 may be formed of an alternating stack of the silicon germanium layers 12 and the monocrystalline silicon layers 14'.

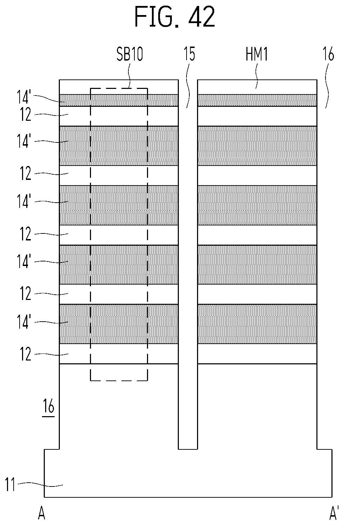

Referring to FIG. 42, a hard mask layer pattern HM1 may be formed over the stack body SB10.

The stack body SB10 may be etched by using the hard mask layer pattern HM1 as an etch barrier. As a result, a plurality of first and second vertical openings 15 and 16 may be formed in the stack body SB10.

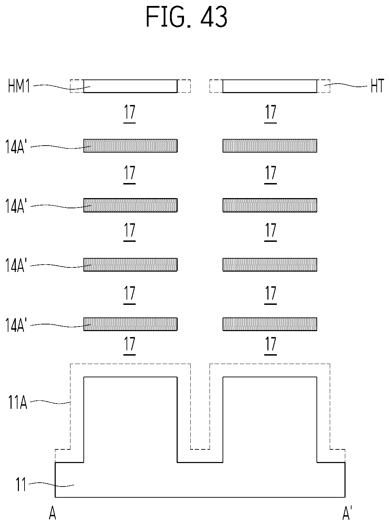

Referring to FIG. 43, preliminary horizontal layers 14A' and horizontal recesses 17 may be formed. The preliminary horizontal layers 14A' and the horizontal recesses 17 may be formed by a recess process of the silicon germanium layers 12 and the monocrystalline silicon layers 14' of FIG. 42. After the silicon germanium layers 12 are removed, a recess process of the monocrystalline silicon layers 14' may be performed. The preliminary horizontal layers 14A' may correspond to the preliminary horizontal layers 14A of FIG. 6.

The silicon germanium layers 12 may be recessed by a wet etching process or a dry etching process. The silicon germanium layers 12 may be etched by using an etchant or an etching gas having a selectivity with respect to the monocrystalline silicon layers 14'.

The recess process of the monocrystalline silicon layers 14' for forming the preliminary horizontal layers 14A' may use, for example, HSC1 (Hot SC-1). HSC1 may include a solution of ammonium hydroxide (NH₄OH), hydrogen peroxide (H₂O₂), and water (H₂O) that are mixed at a ratio of approximately 1:4:20. The monocrystalline silicon layers 14' may be selectively etched by using HSC1.

While the preliminary horizontal layers 14A' are formed, the surface of the lower structure 11 may be recessed to a predetermined depth (see reference numeral '11A'). As a result, the depth of the first and second vertical openings 15 and 16 may be increased.

Subsequently, a series of the processes illustrated in FIGS. 8 to 31 may be performed.

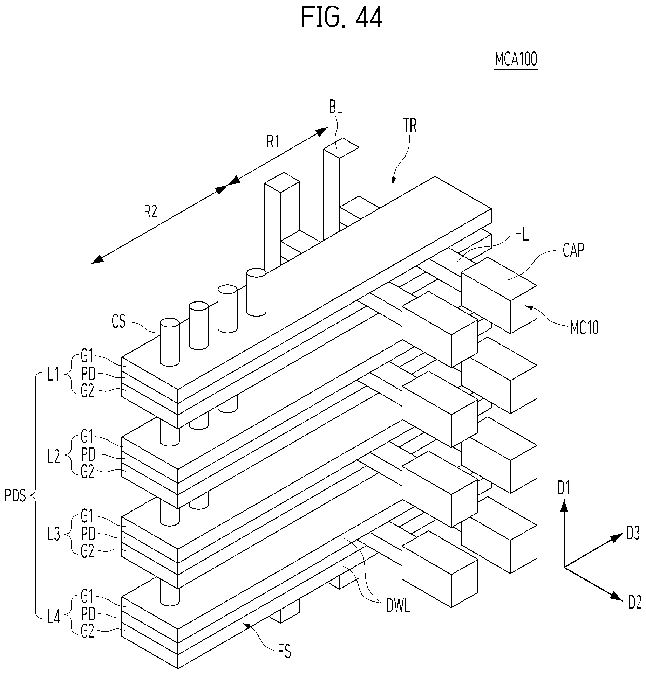

FIGS. 44 to 46 are perspective views illustrating memory cell arrays in accordance with other embodiments of the present disclosure. The memory cell arrays MCA100, MCA200 and MCA300 may be similar to the vertical memory cell array MV1 of FIG. 3C. Hence, the above detailed descriptions of the constituent elements also appearing in FIG. 3C may be referred to.

The memory cell arrays MCA100, MCA200 and MCA300 may include a first region R1 where memory cells are disposed, and a second region R2 where the connection portion PDS is disposed.

Referring to FIG. 44, the memory cell array MCA100 may include a plurality of memory cells MC10.

The memory cell array MCA100 may include a three-dimensional array of memory cells MC10. The three-dimensional array of memory cells MC10 may include a column array of the memory cells MC10 and a row array of the memory cells MC10. The column array of the memory cells MC10 may include a plurality of memory cells MC10 that are stacked in the first direction D1, and the row array of the memory cells MC10 may include the memory cells MC10 that are arranged horizontally in the second direction D2 and the third direction D3.

Each of the memory cells MC10 may include a first conductive line BL, a switching element TR, and a data storage element CAP. As for the detailed descriptions on the first conductive line BL and the data storage element CAP, the above-described embodiments of the present disclosure may be referred to.

The switching element TR may include a horizontal layer HL and a second conductive line DWL. The horizontal layer HL may extend in the second direction D2. The second conductive line DWL may extend in the third direction D3.

The second conductive line DWL may have a double structure. For example, the second conductive line DWL may include an upper horizontal line G1 and a lower horizontal line G2 that are facing each other with the horizontal layer HL interposed therebetween. As illustrated in FIGS. 1B and 3B, an inter-level dielectric layer GD may be formed on the upper and lower surfaces of the horizontal layer HL.

Each of the upper horizontal line G1 and the lower horizontal line G2 may include a pair of flat sidewalls FS that extend in the third direction D3. The flat sidewall FS may refer to a vertical sidewall. The flat sidewall FS may have a linear shape that extends in the third direction D3.

The second conductive lines DWL may include a plurality of levels L1, L2, L3 and L4. For example, the first level L1 may refer to the second conductive line DWL of the uppermost level, and the fourth level L4 may refer to the second conductive line DWL of the lowermost level. The second level L2 may be a lower level than the first level L1, and the third level L3 may be a lower level than the second level L2. The fourth level L4 may be a lower level than the third level L3. The fourth level L4, the third level L3, the second level L2, and the first level L1 may be stacked in the first direction D1 in the mentioned order. Each of the second conductive lines DWL of the levels L1 to L4 may include a pair of an upper horizontal line G1 and a lower horizontal line G2.

The connection portion PDS of the second conductive lines DWL may include a plurality of levels L1, L2, L3 and L4. In the connection portion PDS, each of the second conductive lines DWL of the levels L1 to L4 may include a pair of an upper horizontal line G1 and a lower horizontal line G2. In the connection portion PDS, the levels L1 to L4 may further include pads PD. The pads PD may be disposed between the upper horizontal line G1 and the lower horizontal line G2. The pads PD may be electrically connected to the upper horizontal line G1 and the lower horizontal line G2.

The horizontal lengths of the pads PD in the third direction D3 may be the same. The pads PD and the horizontal layers HL may be spaced apart from each other. The pads PD may not be disposed in the first region R1.

In the connection portion PDS, the levels L1 to L4 may contact the contact structures CS.

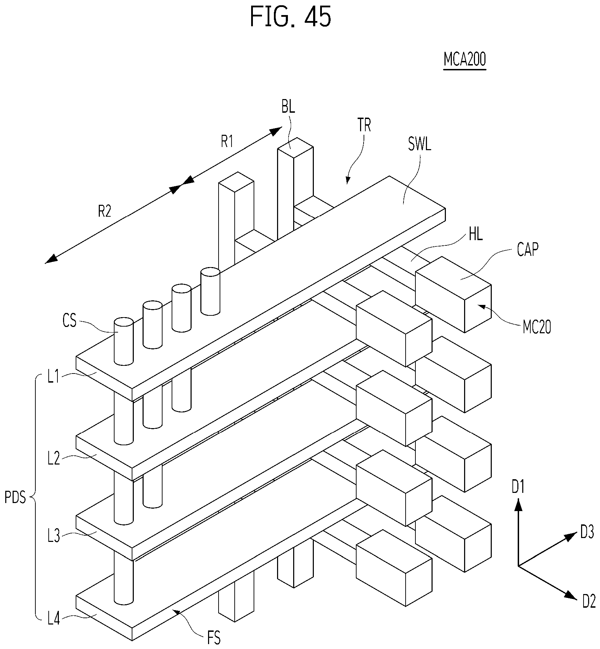

Referring to FIG. 45, the memory cell array MCA200 may include a plurality of memory cells MC20.

The memory cell array MCA200 may include a three-dimensional array of memory cells MC20. The three-dimensional array of the memory cells MC20 may include a column array of memory cells MC20 and a row array of memory cells MC20. The column array of the memory cells MC20 may include a plurality of memory cells MC20 that are stacked in the first direction D1, and the row array of the memory cells MC20 may include the memory cells MC20 that are horizontally arranged in the second direction D2 and the third direction D3.

Each of the memory cells MC20 may include a first conductive line BL, a switching element TR, and a data storage element CAP. As for the detailed description of the first conductive line BL and the data storage element CAP, the above-described embodiments of the present disclosure may be referred to.

The switching element TR may include a horizontal layer HL and a second conductive line SWL. The horizontal layer HL may extend in the second direction D2. The second conductive line SWL may extend in the third direction D3.

The second conductive line SWL may have a single structure. For example, the second conductive line SWL may be disposed over the horizontal layer HL. As illustrated in FIGS. 1B and 3B, an inter-level dielectric layer GD may be formed between the upper surface of the horizontal layer HL and the second conductive line SWL. According to another embodiment of the present disclosure, the second conductive line SWL may be disposed below the horizontal layer HL.

The second conductive line SWL may include a pair of flat sidewalls FS that extend in the third direction D3. The flat sidewalls FS may refer to vertical sidewalls.

According to another embodiment of the present disclosure, the second conductive line SWL may include a channel overlapping portion WLP and a channel non-overlapping portion NOL, as illustrated in FIG. 1C.

The second conductive lines SWL may include a plurality of levels L1, L2, L3 and L4. For example, the first level L1 may refer to the second conductive line SWL of the uppermost level, and the fourth level L4 may refer to the second conductive line SWL of the lowermost level. The second level L2 may be a lower level than the first level L1, and the third level L3 may be a lower level than the second level L2. The fourth level L4 may be a lower level than the third level L3. The fourth level L4, the third level L3, the second level L2, and the first level L1 may be stacked in the first direction D1 in the mentioned order. Each of the second conductive lines SWL of the levels L1 to L4 may have a single structure.

The connection portion PDS of the second conductive lines SWL may include a plurality of levels L1, L2, L3 and L4. Each of the second conductive lines SWL of the levels L1 to L4 in the connection portion PDS may have a single structure. The levels L1 to L4 of the connection portion PDS may directly contact the contact structures CS.

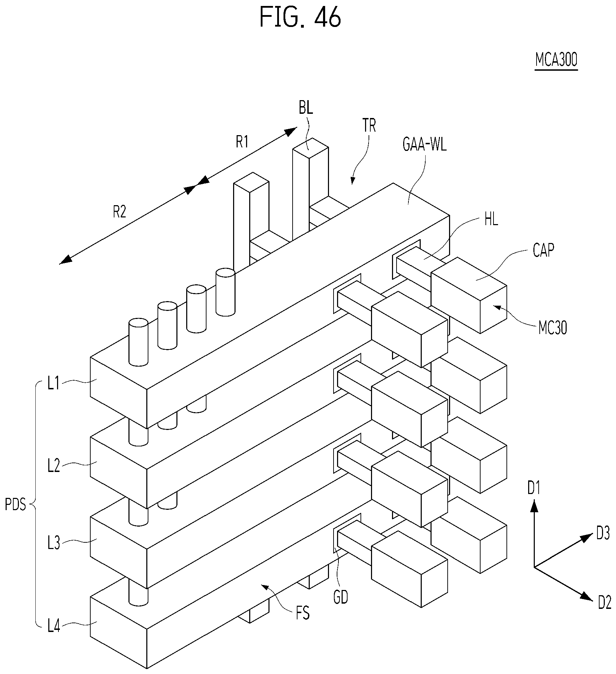

Referring to FIG. 46, the memory cell array MCA300 may include a plurality of memory cells MC30.

The memory cell array MCA300 may include a three-dimensional array of memory cells MC30. The three-dimensional array of the memory cells MC30 may include a column array of memory cells MC30 and a row array of memory cells MC30. The column array of the memory cells MC30 may include a plurality of memory cells MC30 that are stacked in the first direction D1, and the row array of the memory cells MC30 may include a plurality of memory cells MC30 that are horizontally arranged in the second direction D2 and the third direction D3.

Each of the memory cells MC30 may include a first conductive line BL, a switching element TR, and a data storage element CAP. As for the detailed descriptions on the first conductive line BL and the data storage element CAP, the above-described embodiments may be referred to.

The switching element TR may include a horizontal layer HL and a second conductive line GAA-WL. The horizontal layer HL may extend in the second direction D2 and the second conductive line GAA-WL may extend in the third direction D3.

The second conductive line GAA-WL may have a gate-all-around structure GAA. For example, the second conductive line GAA-WL may extend in the third direction D3 while surrounding the horizontal layers HL. An inter-level dielectric layer GD may be formed between the horizontal layer HL and the second conductive line GAA-WL. An inter-level dielectric layer GD may surround the individual horizontal layers HL.

The second conductive line GAA-WL may include a pair of flat sidewalls FS that extend in the third direction D3. The flat sidewalls FS may refer to vertical sidewalls.

The second conductive lines GAA-WL may include a plurality of levels L1, L2, L3 and L4. For example, the first level L1 may refer to the second conductive line GAA-WL of the uppermost level, and the fourth level L4 may refer to the second conductive line GAA-WL of the lowermost level. The second level L2 may be a lower level than the first level L1, the third level L3 may be a lower level than the second level L2 and the fourth level L4 may be a lower level than the third level L3. The fourth level L4, the third level L3, the second level L2, and the first level L1 may be stacked in the first direction D1 in the mentioned order. Each of the second conductive lines GAA-WL of the levels L1 to L4 may have a gate-all-around structure.

The connection portion PDS of the second conductive lines GAA-WL may include a plurality of levels L1, L2, L3 and L4. Each of the second conductive lines GAA-WL of the levels L1 to L4 in the connection portion PDS may have a gate-all-around structure. The levels L1 to L4 of the connection portion PDS may directly contact the contact structures CS.

According to another embodiment of the present disclosure, each of the memory cells may include the first conductive line BL extending horizontally in the third direction D3, the second conductive line DWL extending vertically in the first direction D1, and the horizontal layer HL extending horizontally in the second direction D2. The second conductive line DWL may have a double structure, which may be replaced with a single structure or a gate-all-around structure.

According to another embodiment of the present disclosure, the semiconductor device may include a plurality of first conductive layers 29 vertically stacked in the first direction D1 over the lower structure 11 of the first region R1; a second region R2 including a plurality of second conductive layers L1 to L4 that are stacked in the first direction D1 over the lower structure 11 of the region R2 and have the same horizontal length; a plurality of contact structures CS respectively coupled to the second conductive layers L1 to L4. Each of the second conductive layers L1 to L4 may include a first horizontal conductive line 29A, a second horizontal conductive line 29B, and a pad PD between the first horizontal conductive line 29A and the second horizontal conductive line 29B. The horizontal lengths in the third direction D3 of the first horizontal conductive line 29A, the second horizontal conductive line 29B, and the pad PD may be the same. The first conductive layers 29 may further include the first horizontal conductive line 29A, the second horizontal conductive line 29B, and the horizontal layer HL between the first horizontal conductive line 29A and the second horizontal conductive line 29B. The first conductive layers 29 may correspond to the horizontal conductive lines 29 of FIG. 31, and the second conductive layers L1 to L4 may correspond to the levels L1 to L4 of FIG. 31.

Since the connection portion of the horizontal conductive lines are formed in a stair-less structure according to the present technology, the occupied area (or volume) of the connection portion may be decreased.

While embodiments of the present disclosure have been described with respect to specific embodiments, it will be apparent to those skilled in the art that various changes and modifications may be made without departing from the spirit and scope of the present disclosure as defined in the following claims. Therefore, the scope of the present disclosure should not be limited to the above-described embodiments but should include the equivalents thereof.

In the above-described embodiments, all operations may be selectively performed, or part of the operations may be omitted. In each embodiment, the operations are not necessarily performed in accordance with the described order and may be rearranged. The embodiments disclosed in this specification and drawings are only examples to facilitate an understanding of the present disclosure, and the present disclosure is not limited thereto. That is, it should be apparent to those skilled in the art that various modifications can be made on the basis of the technological scope of the present disclosure.

The embodiments of the present disclosure have been described in the drawings and specification. Although specific terminologies are used here, those are only to describe the embodiments of the present disclosure. Therefore, the present disclosure is not restricted to the above-described embodiments and many variations are possible within the scope of the present disclosure. It should be apparent to those skilled in the art that various modifications can be made on the basis of the technological scope of the present disclosure in addition to the embodiments disclosed herein. Furthermore, the embodiments may be combined to form additional embodiments.

## Claims

1. A semiconductor device, comprising:
a lower structure;
a first region including a plurality of first conductive layers vertically stacked in a first direction over the lower structure;
a second region including a plurality of second conductive layers stacked in the first direction, the second conductive layers having the same horizontal length; and
a plurality of contact structures coupled to the second conductive layers, respectively,
wherein each of the second conductive layers includes
a first horizontal conductive line;
a second horizontal conductive line; and
a pad between the first horizontal conductive line and the second horizontal conductive line.

2. The semiconductor device of claim 1, wherein the first horizontal conductive line, the second horizontal conductive line, and the pad have the same horizontal length.

3. The semiconductor device of claim 1, wherein each of the first conductive layers includes
an upper horizontal conductive line extending from the first horizontal conductive line; and
a lower horizontal conductive line extending from the second horizontal conductive line.

4. The semiconductor device of claim 1, wherein each of the first conductive layers includes:
an upper horizontal conductive line extending from the first horizontal conductive line;
a lower horizontal conductive line extending from the second horizontal conductive line; and
a horizontal layer between the first horizontal conductive line and the second horizontal conductive line.

5. The semiconductor device of claim 1, wherein each of the contact structures includes:
a plurality of contact plugs respectively coupled to the second conductive layers; and
contact spacers respectively disposed on sidewalls of the contact plugs.

6. The semiconductor device of claim 1, wherein each of the contact structures includes
a plurality of contact plugs respectively coupled to the second conductive layers, and
the contact plugs have a structure whose height gradually decreases in a direction that the second conductive layers are stacked.

7. The semiconductor device of claim 1, wherein the contact structure includes
a deep contact plug coupled to a lowermost-level second conductive layer among the second conductive layers, and
the deep contact plug includes a shape that vertically penetrates the second conductive layers.

8. The semiconductor device of claim 1, wherein the first conductive layers and the second conductive layers include the same material.

9. A method for fabricating a semiconductor device, the method comprising:
forming a first stack of first conductive layers each including a pair of an upper horizontal conductive line and a lower horizontal conductive line over a lower structure;
forming a second stack of second conductive layers each including a first horizontal conductive line, a second horizontal conductive line, and a pad between the first horizontal conductive line and the second horizontal conductive line over the lower structure;
forming contact holes whose height gradually decreases in a direction that the second conductive layers are stacked in the second stack; and
forming contact plugs respectively coupled to the second conductive layers exposed by the contact holes.

10. The method of claim 9, wherein the first horizontal conductive line, the second horizontal conductive line, and the pad are formed to have the same horizontal length.

11. The method of claim 9, wherein the forming of the contact holes includes
etching the second stack into a step-less structure using a plurality of masks and a plurality of etching processes.

12. The method of claim 9, wherein the contact holes include
a shape that sequentially penetrates the second conductive layers of the second stack in a direction that the second conductive layers are stacked.

13. The method of claim 9, wherein the first horizontal conductive line extends from the upper horizontal conductive line, and
the second horizontal conductive line extends from the lower horizontal conductive line.

14. The method of claim 9, wherein the first stack further includes
a horizontal layer of the upper horizontal conductive line and the lower horizontal conductive line.

15. The method of claim 9, further comprising:
forming contact spacers on sidewalls of the contact holes, after the forming of the contact holes.

16. The method of claim 9, wherein the forming of the contact holes includes
forming the contact holes by an etching process of the second conductive layers,
wherein the etching process include a one-layer etching process, a three-layer etching process, a five-layer etching process, or a combination thereof.

17. A semiconductor device, comprising:
a lower structure;
a cell array region including a plurality of horizontal conductive lines vertically stacked in the first direction over the lower structure;
a connection region including a plurality of levels stacked in the first direction and having the same horizontal length; and
a plurality of contact structures respectively coupled to the levels,
wherein each of the levels includes
a first horizontal conductive line;
a second horizontal conductive line; and
a pad between the first horizontal conductive line and the second horizontal conductive line.

18. A semiconductor device, comprising:
an alternating stack of conductive layers and dielectric layers disposed over a lower structure; and
an array of contact plugs disposed in the alternating stack, horizontally spaced apart from each other in a first horizontal direction, and having different heights,
wherein top surfaces of the contact plugs are disposed on the same horizontal plane, and bottom portions of the contact plugs are coupled to the conductive layers, respectively, and
wherein the contact plugs penetrating an uppermost conductive layer are laterally surrounded by the conductive layers and are laterally surrounded by the conductive layers laid over the conductive layers adjoined with the contact structure.
